# EUROPEAN PATENT APPLICATION

(11) **EP 4 092 865 A1**
(43) Date of publication of application: **23.11.2022**
(21) Application number: 22161592.5
(22) Date of filing: 11.03.2022
(51) Int. Cl.: H02J 7/00, G06F 1/3231, G06F 1/3296, H02M 3/07

(54) **ADAPTIVE INPUT VOLTAGE SELECTION FOR A REGULATOR, CONTEXTUAL BATTERY CHARGER, AND OPTIMIZED POWER DELIVERY FOR CLAMSHELL SYSTEMS**

(30) Priority: 18.05.2021 US 202117323862
(71) Applicant: INTEL Corporation, Santa Clara, CA 95054 (US)
(72) Inventor: SINGH, Jagadish, Bangalore (IN); BEDARE, Sachin, 560035 Bangalore KA (IN); PARCHURU, Anoop, 560048 Bangalore, Karnataka (IN); G, Govindaraj, 560037 Bangalore KA (IN); CHANDRASEKHARA, Vinaya Kumar, 560037 Bangalore, Karnataka (IN); KOKI, Tarakesava Reddy, Hyderabad (IN); BHAT, Praveen Kashyap Ananta, Bangalore (IN); RAO, Raghavendra, 560072 Bangalore KA (IN); HANCHATE, Mallari, 586103 Bangalore KA (IN); NGUYEN, Don, Portland, 97231 (US)
(74) Representative: Viering, Jentschura & Partner mbB Patent- und Rechtsanwälte

(57) **Abstract**

A computing system having a high-performance battery pack (e.g., 3S, 4S battery packs) coupled to a voltage regulator and logic to control an input supply of the voltage regulator. The logic determines the context of usage of the computing device (or user attentiveness) and either dynamically bypasses the voltage regulator to provide the voltage from the high-performance battery pack directly to various components of the computing system, or dynamically engages devices of the voltage regulator to provide a lower supply voltage to the various components of the computing system.

## Description

### BACKGROUND

Most clamshell computing devices have batteries based on Lithium Ion technology. These batteries are connected as series cells. The higher the number of series cells, faster the performance experienced by a user of the clamshell computing device due to higher power level (e.g., PL4) that can be supported. Higher number of series cells has become popular because of the ability to fast-charge (e.g., 1C charge rate for 80Whr/2S is approximately 10.4A versus 1C charge rate for 80Whr/4S is approx., 5.2A) and the ability to support higher power levels (e.g., PL4) due to a larger voltage gap between system minimum operating voltage (Vsysmin), which is typically 5.6V on most systems based on a 5V buck regulator. For 2S battery pack (e.g., 2 series cells) with voltage in a range of 6V to 8.8V, the voltage gap from Vsysmin is 0.4 V. Conversely, for 4S battery pack (e.g., 4 series cells). With voltage in a range of 12V to 17.6V, the voltage gap from Vsysmin is 6.4V making Vsysmin voltage level irrelevant.

At a glance, a 4S based battery system looks promising in terms of charge rate and performance, but the efficiency in conversion is lower due to higher cross-over losses in legacy power-delivery (PD) implementation (battery voltage directly converted to core voltages) affecting battery life in low power or light workloads (performance workloads with a rare demand for PL4) such as Netflix, local VPN, browsing, idle screen, standby etc. A 2S based system may operate better for the battery life for workloads described above, but would not be able to offer performance due to small voltage gap to the Vsysmin.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
**Fig. 1** illustrates a high-level architecture for contextual input voltage selection for optimal power delivery, in accordance with some embodiments.
**Fig. 2** illustrates a set of plots showing power-level 2 (PL2) and PL4 supported by a system-on-chip on 2S and 4S configuration batteries.
**Fig. 3** illustrates an architecture for contextual input voltage (Vin) selection and output voltage (Vout) selection for optimal power delivery, in accordance with some embodiments.
**Fig. 4** illustrates a switched capacitor voltage regulator (SCVR) in voltage divider mode, in accordance with some embodiments.
**Fig. 5** illustrates a SCVR in bypass mode, in accordance with some embodiments.
**Fig. 6** illustrates a clamshell device with architecture for contextual input voltage selection for optimal power delivery, in accordance with some embodiments.
**Fig. 7** illustrates a detailed flowchart of a method for contextual input voltage selection for optimal power delivery, in accordance with some embodiments.
**Fig. 8** illustrates an architecture for contextual usage of VR in a charger during DC mode to improve battery life and performance, in accordance with some embodiments.
**Fig. 9** illustrates an SCVR during AC mode, in accordance to some embodiments.
**Fig. 10** illustrates SCVR charger as voltage divider during DC mode, in accordance with some embodiments.
**Fig. 11** illustrates SCVR charger as voltage bypass mode during DC mode, in accordance with some embodiments.
**Fig. 12** illustrates a flowchart of a method for contextual usage of VR in a charger during DC mode to improve battery life and performance, in accordance with some embodiments.
**Fig. 13** illustrates a clamshell computing device where a base segment provides multiple power supply voltages to the lid segment.
**Fig. 14** illustrates a clamshell computing device where a single power supply line from one segment to another is used with dynamic VR conversion ratio to supply power in various modes to loads of the clamshell computing device, in accordance with some embodiments.
**Fig. 15** illustrates a power delivery architecture that uses a single power supply line from one segment of a clamshell computing device to generate multiple supplies for different loads for different contexts, in accordance with some embodiments.
**Fig. 16** illustrates a plot showing voltage variation at the battery terminal over the State-of-charge with different loads, in accordance with some embodiments.
**Fig. 17** illustrates a plot showing efficiency in 3.3V power generation when the input voltage to this buck regulator changes from 3.6V (3:1) to 5.4V (2:1), in accordance with some embodiments.
**Fig. 18** illustrates a system-on-chip (SoC) with apparatus for contextual input voltage selection for optimal power delivery, in accordance with some embodiments.

### DETAILED DESCRIPTION

In some embodiments, a computing system such as a clamshell-based device comprises a high-performance battery pack (e.g., 3S, 4S or higher series cell-based battery packs) coupled to a voltage regulator and logic to control an input supply of the voltage regulator. In some embodiments, the logic determines the context of usage of the computing device and either dynamically bypasses the voltage regulator to provide the voltage from the high-performance battery pack directly to various components of the computing system, or dynamically engages devices of the voltage regulator to provide a lower supply voltage to the various components of the computing system. Here, dynamic refers to real-time or near real-time automatic action. For example, without user intervention, the logic of various embodiments determines the context of user behavior, user attentiveness, user engagement, user interaction with the computing device workload type, day or time, battery state-of-charge and other parameters to determine whether to bypass the voltage regulator and provide battery voltage (e.g., 4S battery cell) directly to the system load or to divide down the battery voltage (e.g., divide it by two) and provide the divided voltage to the system load (e.g., system components). The logic can be part of a system-on-chip, a standalone integrated circuit (IC) chip, or integrated in any suitable logic chip. While various embodiments describe the voltage regulator as a switched capacitor voltage regulator (SCVR), any suitable regulator may be used.

In some embodiments, when the logic determines that the user is interactive or engaged, the SCVR is placed in bypass mode to deliver performance at 4S battery voltage levels. In some embodiments, when the logic determines that the user is less engaged or disengaged from the computing device, or completely absent or away from the computing device, the SCVR is placed in a voltage divider mode to deliver longer battery life by providing a 2S battery voltage level. As such, a scheme is provided where it is possible to contextually and dynamically avail the benefit of longer battery life with effective lower voltage battery configuration (e.g., 2S configuration) and higher performance and quick charge capabilities with higher voltage battery configuration (e.g., 4S configuration) by the use of a switched capacitor-based power conversion. The scheme also makes it possible to reduce area and cost for the SCVR implementation, for example, by more than 50% compared with a straightforward SCVR solution to cater full system load.

There are many technical effects of the various embodiments. For example, higher voltage regulation efficiency is achieved due to lower input supply voltage (for downstream regulator(s)) during battery life workload scenarios. The embodiments provide higher performance (e.g., fast charging) with higher input voltage during performance workload scenarios (e.g., applications operating in Turbo mode). In some embodiments, SCVR operation of down conversion is used only when delivering power during battery-life workloads, and this allows for reduction in SCVR area and cost by more than 50%. During performance mode (e.g., turbo mode), the SCVR operates in bypass mode where the SCVR output power is doubled compared to when it operates in say 2:1 mode. In one such example, the current is the same but the output voltage is doubled. Other technical effects will be evident from the various embodiments and figures.

A computing device includes a charger circuit that converts power from an adaptor (e.g., a wall adapter) to system/battery requirements. But during a DC mode of operation, the charger power conversion circuit lies effectively un-utilized. From a layman's point of view, the charger circuit is dead-weight during portable mode though a controller of the charger circuit does handle some other aspects like battery discharge control. At a glance, a 4S battery-based system looks promising in terms of charge rate and performance, but the efficiency in conversion is lower due to higher cross-over losses in legacy power delivery implementation (battery voltage directly converted to core voltages) affecting battery life in low power or light workloads (performance workloads with a rare demand for PL4) such as Netflix, local VPB, browsing, idle screen, standby etc. A 2S based system would be ideal for the battery life workloads described above but would not be able to offer performance due to small voltage gap to the V_{sysmin}. The benefits that an SCVR based solution (to implement 4S to 2S conversion) brings to a given design is obviously with an increase in the bill-of-material (BOM) cost and real estate in comparison with a solution that does not employ such an intermediate conversion stage. This is a deterrent to wide adoption of SCVR to implement 4S to 2S conversion.

SCVR solutions are evolving and bring benefits in terms of area, overall efficiency and z-height of the Power Delivery Network (PDN) solution. SCVR based chargers can be used in system designs with 1S through 4S or higher battery configurations. SCVR based chargers also benefit from Universal Serial Bus (USB) Type-C Programmable Power Supply (PPS) specification and EPR (Extended Power Range) specification to negotiate for an input voltage closest to 2x battery voltage (which means 2x the output current) and where the power conversion topology reduces overall charger losses.

Some embodiments avoid having a separate SCVR in the design and use existing SCVR circuit blocks available within a hybrid SCVR based charger by merely adding an additional field effect transistor (FET), internal or external to the charger circuit, during DC mode. The SCVR blocks within the charger allow for improved battery life and performance benefits when tied to Machine-Learning based Dynamic Tuning Technology framework (ML-DTT). The hybrid SCVR based charger of some embodiments allow for N:1 (e.g., 2:1) or bypass mode of operation based on user attentiveness and environmental context (e.g., day, time, place) of the computing system. In the N:1 mode, the hybrid SCVR based charger provides a divided output voltage compared to an input supply (e.g., from a 4S battery), wherein the divided output voltage is then used to power the system load (e.g., system-on-chip and other components) either through downstream VRs or directly. In the bypass mode, the hybrid SCVR based charger bypasses the SCVR in the charger circuit and provides the battery supply (e.g., 4S) directly as the output supply for the system load. As the circuit blocks of an SCVR that would otherwise be outside of the charger circuit are re-utilized within the charger circuit, real estate and BOM is reduced. Other technical effects will be evident from the various figures and embodiments.

Convertible and clamshell system design is majorly divided into LID (display side) and BASE (keyboard side). The LID contains an embedded display panel, vision companion chip(s), sensors (e.g., camera, motion etc.) and audio mic interfaces in majority of the designs. On the LID, the embedded display panel may use logic power at 3.3V and backlight power at V_{BKLT}. In one typical example, sensors, camera and audio interfaces need additional 3.3V, 2.8V, 1.2V, 0.9V and 1.8V supplies (multiple instances based on implementation). These voltages can be derived from traditional mainboard approach where mainboard VRs in the BASE generate and supply the required voltages to the display panel (TCON PCB), and to sensor and audio modules through hinge cables. In some embodiments, the voltages can be provided using a single rail from battery using V_{BATA} rail. V_{BATA} rail is routed to TCON PCB on the panel and TCON PCB locally generates voltages for display, and sensor and audio interfaces. Using a single rail may be preferred due to possibility of achieving an overall more efficient power conversion on the LID because of the use of novel switched capacitor topologies, in accordance with some embodiments. Using a single rail also reduces the number of power cables, allowing the hinge diameter to be minimal.

During burst or sustained heavy workloads running on the processor SoC in the base, the battery voltage V_{BATA} may droop. Since the output voltage from the switched capacitor topologies is a ratio of the battery voltage, the output voltage will also droop bringing it close or below the minimum input voltage expectation for the 3.3V regulator, especially during the lower state-of-charge of the battery.

Some embodiments provide a method and apparatus of ensuring the output voltage from the VR (e.g., which feeds the 3.3V regulator) does not go below the input power supply Vin minimum requirements, irrespective of the battery state (either voltage droop due to heavy load and/or lower state-of-charge of battery). This is achieved by dynamically changing the VR (e.g., SCVR) conversion ratio based on the battery voltage V_{BATA} and context of system usage (e.g., user attentiveness or usage which decides performance mode or efficient mode). For example, the scheme of some embodiments adaptively varies the conversion ratio of the VBATA to the voltage to downstream VRs based on the user context and/or workload being serviced by the processor.

In some embodiments, the operation of the SCVR is dynamically modified to a lower conversion ratio (e.g., 2:1 in lieu of 3:1) during at least two events. The first event is a high-performance state (as determined by context, workload information) that is expected to cause a drop or droop on the battery voltage, and such a droop may reflect on the SCVR output that can hurt the Lid side power integrity. The second event is lower state-of-charge of the battery. Lowering the conversion ratio benefits from the higher efficiency in conversion with an SCVR implementation (in comparison with direct conversion) till the cutoff point of the battery during discharge while not spending on expensive power conversion parts.

There are many technical effects of dynamically changing the VR conversion ratio. For example, higher conversion efficiency is achieved even at lower state-of-charge of the battery (in comparison with direct conversion). The scheme avoids system failures at lower state-of-charge of the battery during interactive/ or high-performance mode of operation. The scheme results in minimal to no additional cost incurred in implementation given that the switched capacitor power converter is already capable of lower conversion ratios. As such, no energy from the battery is left unutilized. Other technical effects will be evident from the various figures and embodiments.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Note that in the corresponding drawings of the embodiments, signals are represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, as dictated by design needs or preferences, may actually comprise one or more signals that may travel in either direction and may be implemented with any suitable type of signal scheme.

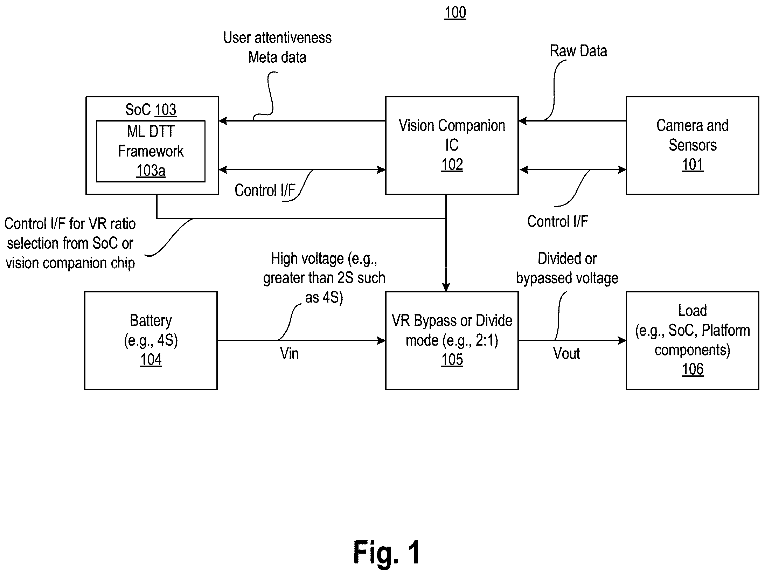

**Fig. 1** illustrates high-level architecture 100 for contextual input voltage selection for optimal power delivery, in accordance with some embodiments. Architecture 100 comprises sensors 101 (e.g., camera, audio, accelerometer, biosensors, etc.), integrated circuit (IC) 102 to process user eye movement, system-on-chip (SoC) 103, battery 104 (e.g., 4S battery), voltage regulator (VR) 105, and load 106 (e.g., SoC 103 and other platform components). In some embodiments, sensor(s) 101 provide raw data (e.g., frames from a camera feed) to IC 102. IC 102 can be low power vision companion chip that processes the raw data from sensor 101 to process user eye movement. When eyes of the user are focused on the display for a certain threshold time (e.g., a programmable or fixed time), user's behavior is considered attentive. IC 102 determines user attentiveness by processing user eye movement on the display or keyboard. The output of IC 102 is user attentiveness meta data which is provided to SoC 103 for processing.

In some embodiments, SoC 103 includes a machine-learning (ML) based dynamic tuning technology (DTT) such as Intel^{®} DTT 103a. In addition, the DTT software, drivers, and/or hardware performs fine-tuning power allocations between a graphics processor unit (GPU) and a central processing unit (CPU) dynamically to provide the best power allocation based on user workload. For example, DTT updates the power policy of the GPU to allow higher performance (and thus use more power) under graphics-heavy workloads (e.g., gaming). In that case, DTT reduces the power budget of the CPU when GPU power budget is increased. Likewise, for workloads where the GPU is not needed entirely, it may be disabled or go in deep idle states and process everything on the integrated graphics while giving the CPU most of the power budget to speed-up CPU-dependent workloads.

In some embodiments, ML-DTT 103a determines from the meta data from IC 102 that the user is interactive or engaged. Based on that determination, a power control unit or ML-DTT 103a places SCVR 105 in bypass mode to deliver performance at 4S battery voltage levels. For example, a control interface (I/F) from SoC 103 may provide control for VR ratio selection for VR 105. In some embodiments, IC 102 may also provide control for VR ratio selection for VR 105 based on user attentiveness. Any one of the indications (e.g., from SoC 103 or IC 102) can be used by VR 105 to either bypass the VR or provide a divided voltage (e.g., N: 1, where N is a number indicating the voltage divide ratio) as Vout to load 106. In some embodiments, when the logic (e.g., ML-DTT 103a and/or IC 102) determines that the user is less engaged or disengaged from the computing device, or completely absent or away from the computing device or is running a battery-life workload as specified earlier, VR 105 (e.g., SCVR) is placed in a voltage divider mode to deliver longer battery life by providing a 2S battery voltage level. As such, a scheme is provided where it is possible to contextually and dynamically avail the benefit of longer battery life with effective lower voltage battery configuration (e.g., 2S configuration) and higher performance and quick charge capabilities with higher voltage battery configuration (e.g., 4S configuration) by the use of a switched capacitor-based power conversion. The scheme also makes it possible to reduce area and cost for the SCVR implementation, for example, by more than 50% compared with a straightforward SCVR solution to cater full system load.

As such, in some embodiments, based on user attentiveness meta data, ML DTT 103a can decide on one of the following 4 modes of system operation. These four modes are: Interactive Mode (High Performance - High load on battery), Efficient Mode (Power Efficient - Low load on battery), Quiet Mode or Standby Mode. For Interactive mode, High performance is used demanding the highest battery voltage available (e.g., 4S voltage from a 4S battery 104). In case of other modes, the 2S voltage is enough to meet the performance demand, thus achieving higher efficiency.

In various embodiments, battery 104 is a battery having more than two series cells (e.g., 3S, 4S, or more). The output of battery 104 is an input supply Vin to VR 105. As discussed herein, VR 105 is described as a SCVR. However, the embodiments are not limited to that. Other types of VRs can also be used with capability to be bypassed or provide a divided voltage output on node Vout. Here, node names and signal names are interchangeably used. For example, Vout may refer to output supply rail, supply node, or output voltage depending on the context of the sentence. In various embodiments, VR 105 is capable of dividing down the voltage in any suitable ratio as 2:1, 3:1, 4:1 or higher based on the battery config and/or State-of-charge (SoC) of battery 104.

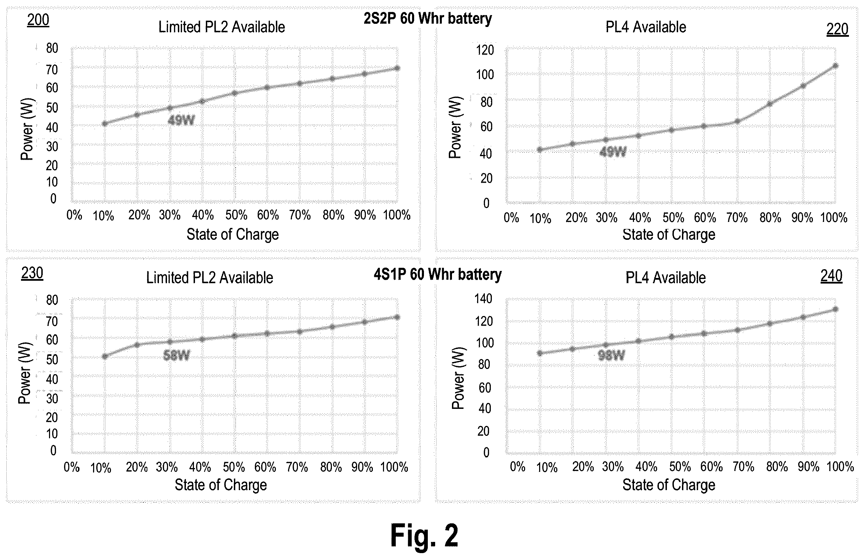

**Fig. 2** illustrates a set of plots 200, 220, 230, and 240 showing power-level 2 (PL2) and PL4 supported by a system-on-chip on 2S and 4S configuration batteries. For each plot, the x-axis is SoC of the battery in percentage while the y-axis is power in Watt (W). 3S and 4S battery configurations are preferred in performance and gaming clamshell designs due to the higher performance that can be delivered as Vsysmin is no longer a concern. Plots 200, 220, 230, and 240 show the PL2 and PL4 numbers that can be supported by a (as an example) 60 Whr 2S2P battery (plots 200 and 220) against a 60Whr 4S1P battery (plots 230 and 240) up to 30% SoC of a battery. The PL2 in the case of the 4S configuration is about 9W higher while the PL4 is about 50W higher.

As is noticeable, the PL4 supported by the 2S battery is not enough to meet the needs of the mobile and performance segment silicon, but with the 4S battery the requirement for mobile and performance (with Thermal Design Power (TDP) less than 28 W) can easily be met. But, on the flipside, the number of hours of Battery Life (BL) that is obtained in the case of the 2S battery config is better than that from the 4S battery config by 24min to 54min based on the workload considered. Table 1 shows a snapshot of the hours of battery life (BL) in each case.

**Table 1**

| | Connected standby on wake-on-voice (WoV) | Idle display on Panel self-refresh (PSR) | Video Playback 1080p24 h264 420 8b | Netflix Streaming | Web browsing EEMBC | Microsoft^{®} Hours of battery life (HOBL) while browsing 4 tab live | Mobilemark 14 | Microsoft HOBL productivity |
|---|---|---|---|---|---|---|---|---|
| 4S1P | 1.3% dec in 8 hr | 28 hr | 18.7 hr | 15.8 hr | 15.3 hr | 12.2 hr | 14.0 hr | 13.9 hr |
| 2S2P | 1.2% dec in 8 hr | 28.9 hr | 19.4 hr | 16.5 hr | 15.7 hr | 12.6 hr | 14.5 hr | 14.4 hr |
| | | **0.9 hr** | **0.7 hr** | **0.7 hr** | **0.4 hr** | **0.4 hr** | **0.5 hr** | **0.5 hr** |

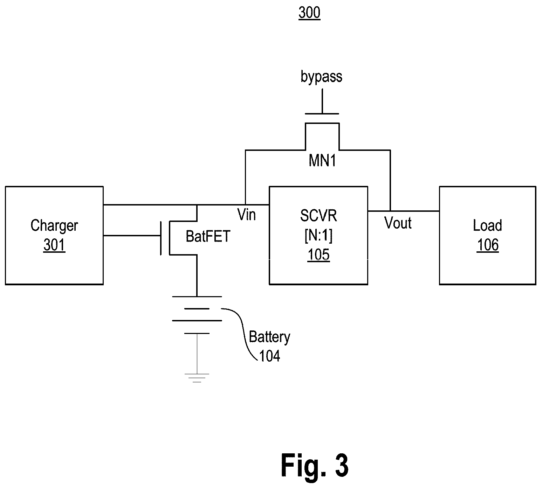

**Fig. 3** illustrates architecture 300 for contextual input voltage selection for optimal power delivery, in accordance with some embodiments. Architecture 300 comprises charger 301, battery field effect transistor (BaFET), battery 104, SCVR 105 with N:1 divide capability, bypass circuitry with transistor MN1, and load 106. In this example battery 104 is a 4S battery, and 'N' is equal to 2 for SCVR 105. However, the embodiments can be extended to any battery size and corresponding voltage divider ratio for SCVR 105. The input supply Vin is provided as output supply Vout directly from charger 301 in bypass mode. In bypass mode, transistor MN1 is turned on to electrically short nodes Vin and Vout. While the embodiments illustrate a simple n-type power gate MN1 to couple nodes Vin and Vout, the power gate MN1 can be replaced with back-back n-type power gates, a p-type power gate, back-back p-type power gates, a combination of n-type and p-type power gates, etc. The control bypass is generated by logic (e.g., ML-DTT 103a and/or IC 102).

In some embodiments, ML-DTT 103a determines from the meta data from 102 that the user is attentive (engaged). Based on that determination, a power control unit or ML-DTT 103a places SCVR 105 in bypass mode to deliver performance at 4S battery voltage levels. When ML-DTT 103a determines from the meta data from IC 102 that the user is less engaged (compared to a threshold level of activity), disengaged or absent altogether, ML-DTT 103a places SCVR 105 in divider mode where Vout is a divided form of Vin. When N=2 and battery 104 is a 4S battery, the output voltage Vout is half of Vin.

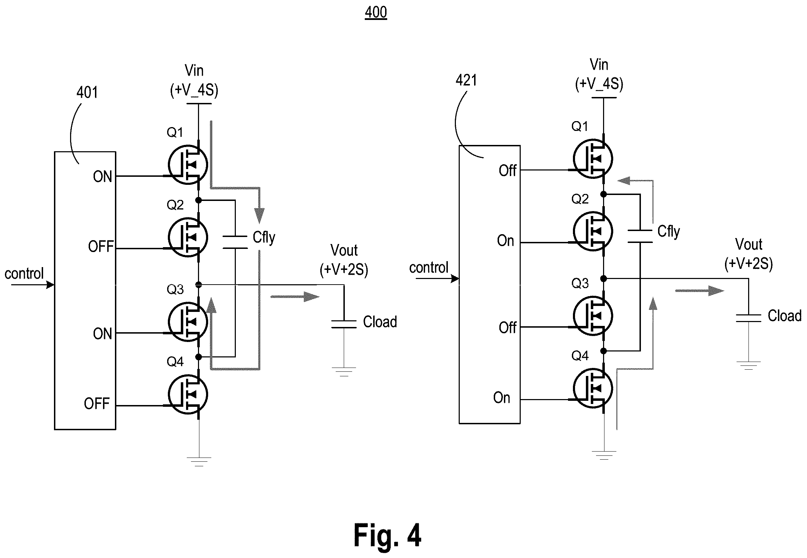

**Fig. 4** illustrates a portion of switched capacitor voltage regulator (SCVR) 400 in voltage divider mode, in accordance with some embodiments. In this simplified figure, SCVR 400 comprises a driver having n-type transistors Q1, Q2, Q3, and Q4 coupled in series, fly capacitor Cfly, and control logic that drives transistors Q1, Q2, Q3, and Q4. Here, control logic is illustrated in two configurations 401 and 421. Transistor Q1 is coupled to the input supply node Vin (e.g., +V 4S) while transistor Q4 is coupled to ground. Capacitor Cfly is coupled to the source terminals of transistors Q1 and Q3. The output supply rail Vout is coupled to a load capacitor Cload (which may represent load 106 or may be a discrete load capacitor). The output supply rail Vout is coupled to the drain terminal of transistor Q3 and the source terminal of transistor Q2. While the embodiment of Fig. 4 shows all n-type transistors, the embodiments are not limited to such. For example, transistors Q1 and Q2 can be p-type transistors while transistors Q3 and Q4 can be n-type transistors. In another example, all transistors of the SCVR driver can be p-type transistors. Regardless of the driver design, the inputs to the gates of the driver transistors can be controlled to provide a voltage divider mode of operation. The description though for a 2:1 converter, can be extended to any N:1 converter used in system designs.

In voltage divider mode, SCVR 400 takes 4S battery input voltage and divides the battery voltage by half and supplies that to system load 106. In one example, divider mode is achieved by turning on transistors Q1 and Q3 while turning off transistors Q2 and Q4. This allows to charge the Cfly capacitor. Thereafter, transistors Q1 and Q3 are turned off and transistors Q2 and Q4 are turned on to provide a 2S voltage on Vout. In various embodiments, at least two alternate transistors in series (e.g., Q1 and Q3 or Q2 and Q4) in voltage regulator 400 are turned off to operate VR 400 in the voltage divider mode. Voltage divider mode is useful during light workloads and sustain loads like video play back, Chrome^{®} browsing, etc. where system power is less, and VR efficiency is important. The efficiency in power conversion for the SCVR is greater than 98%, in this example.

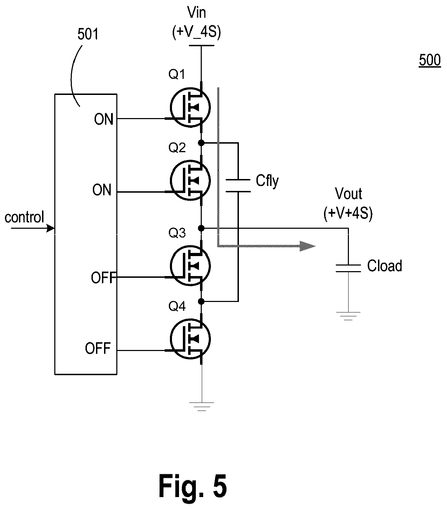

**Fig. 5** illustrates SCVR 500 in bypass mode, in accordance with some embodiments. While **Fig. 3** illustrated a bypass mode where SCVR is bypassed using transistor MN1, in some embodiments SCVR can be bypassed by configuring the driver transistors of SCVR. In this case, driver controller is configured as configuration 501 where transistors Q1 and Q2 are turned on while transistors Q3 and Q4 are turned off. As such, input Vin is electrically shorted to output Vout. In the bypass mode, SCVR 500 takes 4S battery voltage at input Vin and supplies directly to system load 106 without dividing the voltage on Vin. So, the power available at output Vout is double compared to the output in the voltage divider mode of Fig. 4. In the bypass mode, at least two sequentially connected transistors in series (e.g., Q3 and Q4) in voltage regulator 500 are turned off to operate in the bypass mode.

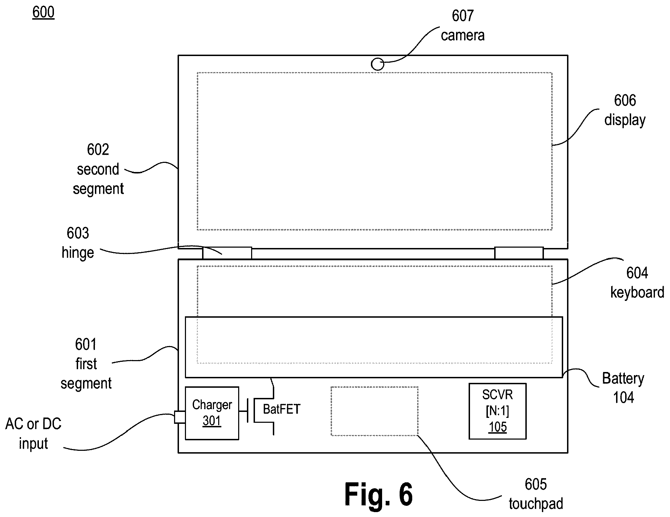

**Fig. 6** illustrates clamshell device 600 with architecture for contextual input voltage selection for optimal power delivery, in accordance with some embodiments. Clamshell device 600 comprises first segment 601 coupled to a second segment 602 via hinges 603. As such, first segment 601 folds over to second segment 602. Clamshell device 600 may include other components such as keyboard 604, touch pad 605, display 606, camera 607 (or 101), and other components of **Fig. 1** and **Fig. 3****.** In various embodiments, charger 301 receives input power from a AC or DC input source and this power is provided as input supply Vin to SCVR 105. Depending on the user attentiveness, ML-DTT 103a or any suitable logic may dynamically or adaptively configure the mode of operation (e.g., bypass mode or voltage divider mode) to provide an optimal user experience and battery life.

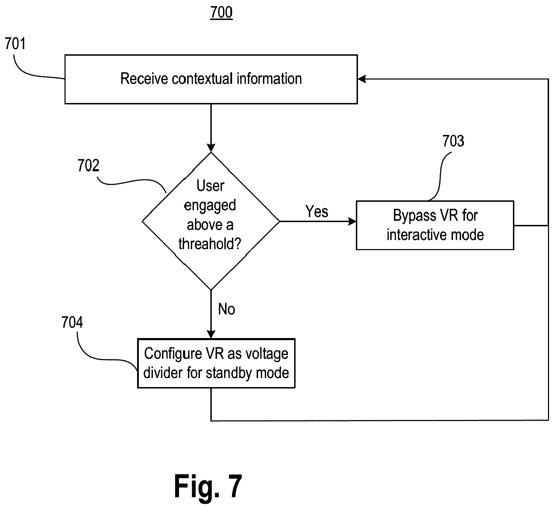

**Fig. 7** illustrates a detailed flowchart 700 of a method for contextual input voltage selection for optimal power delivery, in accordance with some embodiments. While the blocks are shown in a particular order, the order can be modified. For example, some blocks may be performed in parallel, while some blocks can be performed before others. The various blocks can be performed by software, hardware, or a combination of them.

At block 701, SoC 103 (or any suitable logic) receives contextual information. The contextual information may include data about user attentiveness, user habit of using the device (e.g., clamshell device 600), user eye movement data, usage of clamshell device 600 (e.g., whether it is being used for browsing the internet, reading an online book, gaming, etc.), time of the day, day of the week, etc. For instance, a user has a habit of using the clamshell device for browsing at night, working in the day, and off in the afternoon, and these habits are used to dynamically change the operation mode of SCVR 105. In some embodiments, a machine-learning algorithm can be used to predict user behavior or classify user attentiveness as one of user engaged, less engaged, disengaged, or absent as indicated by block 702. Based on the classification, SoC 103 (or any suitable logic) decides whether SCVR should be bypassed (as indicated by block 703) or entered in voltage divide mode as indicated by block 704. In some embodiments, SoC 103 (or any suitable logic) does not use machine-learning but infers user attentiveness by comparing the attentiveness meta data to an overall threshold of activity. If a user engagement is above the threshold, the process proceeds to block 703, otherwise the process proceeds to block 704.

At block 703, VR 105 is bypassed. VR 105 can be bypassed using the scheme of **Fig. 3** (e.g., by turning on the power gate between Vin and Vout) or by configuring the driver control of SCVR 400 as discussed with reference to **Fig. 4****.** The process then proceeds back to block 701 to determine when to change the operation mode of VR 105. At block 704, VR is configured in divide-mode as discussed with reference to **Fig. 5****.** The process then proceeds back to block 701 to determine when to change the operation mode of VR 105. The change in operation mode of VR 105 is dynamic or adaptive in that while the clamshell device is on it may dynamically (in real-time) operate in bypass mode or voltage divider mode depending on user attentiveness. As such, user receives high performance when user desires (e.g., when user is attentive) and longer battery life when user is inactive or less engaged (relative to a threshold) or when running battery-life workloads as described earlier.

In some embodiments, ML-DTT 103a controls the SCVR modes through an I2C I/F or a dedicated single pin control based on the system workload or needs. ML-DTT 103a selects the bypass mode (first mode) during turbo mode where higher PL2 and PL4 numbers are needed and selects the voltage divider mode (second mode) during light and battery-life workloads. In a traditional design approach, the SCVR always operates in 2:1 conversion (voltage divider) and the SCVR is expected to meet the power requirements even during the SoC PL4 and ROP peak power operation. This requires multiple SCVRs working in parallel which takes up a larger real estate and increases bill-of-material (BOM) cost.

Table 2 shows the SCVR modes based on user attentiveness. Here, ML-DTT 103a or any suitable logic puts the SCVR in bypass operation during interactive mode and voltage divider operation mode in all other cases.

**Table 2**

| **User Attentiveness mode** | **Turbo mode** | **SCVR mode** |
|---|---|---|
| Interactive | Enabled | Bypass mode |
| Efficient | Disabled | Voltage Divider |
| Quiet | Disabled | Voltage Divider |
| Standby | Disabled | Voltage Divider |

In some embodiments, the mode of operation can be derived based on whether the system is in AC mode (connected to charger 301) or DC mode (on battery 104). AC could be designated as performance mode where the 4S power is delivered while DC could be where all the different modes for the operation of the SCVR could be employed.

Elements of embodiments are also provided as a machine-readable medium (e.g., memory) for storing the computer-executable instructions (e.g., instructions to implement any other processes discussed herein). In some embodiments, a computing platform comprises a memory, a processor, a machine-readable storage media (also referred to as tangible machine readable medium), a communication interface (e.g., wireless or wired interface), and a network bus coupling them.

In some embodiments, the processor is a Digital Signal Processor (DSP), an Application Specific Integrated Circuit (ASIC), a general-purpose Central Processing Unit (CPU), or a low power logic implementing a simple finite state machine to perform the method of various embodiments, etc.

In some embodiments, the various logic blocks of the system are coupled together via the network bus. Any suitable protocol may be used to implement the network bus. In some embodiments, the machine-readable storage medium includes instructions (also referred to as the program software code/instructions) for intelligent prediction of processor idle time as described with reference to the various embodiments and flowchart.

Program software code/instructions associated with flowchart(s) (and/or various embodiments) and executed to implement embodiments of the disclosed subject matter may be implemented as part of an operating system or a specific application, component, program, object, module, routine, or other sequence of instructions or organization of sequences of instructions referred to as "program software code/instructions," "operating system program software code/instructions," "application program software code/instructions," or simply "software" or firmware embedded in processor. In some embodiments, the program software code/instructions associated with flowchart 700 (and/or various embodiments) are executed by the computer system.

In some embodiments, the program software code/instructions associated with flowchart 700 (and/or various embodiments) are stored in a computer executable storage medium and executed by the processor. Here, computer executable storage medium is a tangible machine-readable medium that can be used to store program software code/instructions and data that, when executed by a computing device, causes one or more processors to perform a method(s) as may be recited in one or more accompanying claims directed to the disclosed subject matter.

The tangible machine-readable medium may include storage of the executable software program code/instructions and data in various tangible locations, including for example ROM, volatile RAM, non-volatile memory and/or cache and/or other tangible memory as referenced in the present application. Portions of this program software code/instructions and/or data may be stored in any one of these storage and memory devices. Further, the program software code/instructions can be obtained from other storage, including, e.g., through centralized servers or peer to peer networks and the like, including the Internet. Different portions of the software program code/instructions and data can be obtained at different times and in different communication sessions or in the same communication session.

The software program code/instructions (associated with flowchart 700 and other embodiments) and data can be obtained in their entirety prior to the execution of a respective software program or application by the computing device. Alternatively, portions of the software program code/instructions and data can be obtained dynamically, e.g., just in time, when needed for execution. Alternatively, some combination of these ways of obtaining the software program code/instructions and data may occur, e.g., for different applications, components, programs, objects, modules, routines or other sequences of instructions or organization of sequences of instructions, by way of example. Thus, it is not required that the data and instructions be on a tangible machine-readable medium in entirety at a particular instance of time.

Examples of tangible computer-readable media include but are not limited to recordable and non-recordable type media such as volatile and non-volatile memory devices, read only memory (ROM), random access memory (RAM), flash memory devices, magnetic random-access memory, ferroelectric memory, floppy and other removable disks, magnetic storage media, optical storage media (e.g., Compact Disk Read-Only Memory (CD ROMS), Digital Versatile Disks (DVDs), etc.), among others. The software program code/instructions may be temporarily stored in digital tangible communication links while implementing electrical, optical, acoustical or other forms of propagating signals, such as carrier waves, infrared signals, digital signals, etc. through such tangible communication links.

In general, the tangible machine readable medium includes any tangible mechanism that provides (i.e., stores and/or transmits in digital form, e.g., data packets) information in a form accessible by a machine (i.e., a computing device), which may be included, e.g., in a communication device, a computing device, a network device, a personal digital assistant, a manufacturing tool, a mobile communication device, whether or not able to download and run applications and subsidized applications from the communication network, such as the Internet, e.g., an iPhone^{®}, Galaxy^{®}, Blackberry^{®} Droid^{®}, or the like, or any other device including a computing device. In one embodiment, processor-based system is in a form of or included within a PDA (personal digital assistant), a cellular phone, a notebook computer, a tablet, a game console, a set top box, an embedded system, a TV (television), a personal desktop computer, etc. Alternatively, the traditional communication applications and subsidized application(s) may be used in some embodiments of the disclosed subject matter.

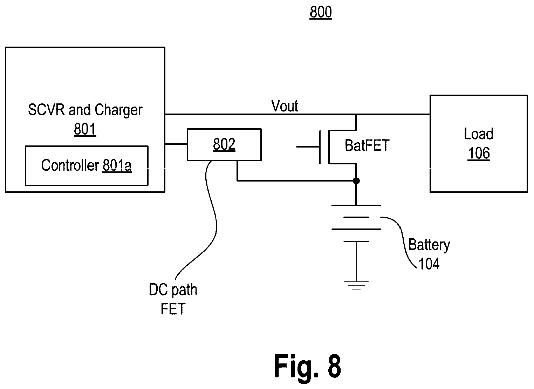

**Fig. 8** illustrates architecture 800 for contextual usage of VR in a charger during DC mode to improve battery life and performance, in accordance with some embodiments. Architecture 800 comprises hybrid charger 801, DC path FET 802, battery FET, Battery 104 (e.g., 4S battery), and load 106. Here, hybrid charger 801 is different from charger 301 in that hybrid charger 801 includes an integrated SCVR which is controllable by controller 801a to operate the SCVR as N:1 (e.g., 2:1) voltage divider or be bypassed depending on user attentiveness and/or context of usage of the computing system. In various embodiments, DC path FET 802 provides an electrical path from battery 104 to hybrid charger 801. This electrical path is enabled by DC path FET 802 during DC mode, and disabled during an AC mode of operation. During AC mode, hybrid charger 801 takes input voltage from an AC source (e.g., from a socket in a wall), and down converts that input voltage to 4S voltage (in case the battery 104 is a 4S battery), based on either traditional Type-C or with EPR specification, and supplies power to battery 104 (to charge it) as well as to system load 106.

In some embodiments, controller 801a controls the DC path FET and operates the SCVR as an N: 1 converter during voltage divider mode. The voltage divider mode is useful during light workloads and can sustain loads like video play back, Chrome browsing etc., where the system power requirement is low and VR efficiency is important. During DC mode, controller 801a configures the driver of SCVR in bypass mode where DC path FET 802 and SCVR FETs are turned off. In bypass mode, BatFET is turned on. An electrical path from battery 104 to Vout supply rail provides 4S power directly to system load 106. So, the power available at the output Vout is higher (due to the larger gap above Vsysmin) in comparison with the voltage divider mode. The bypass mode is useful during performance mode, where a processor or system-on-chip of load 106 needs higher PL2 and PL4 powers. In various embodiments, the criteria for selection between bypass mode or voltage divider mode is same as discussed with reference to **Figs. 1-7**. For example, ML DTT 103a or IC 102 selects the voltage divider mode during light and battery-life workloads, and selects the bypass mode during turbo mode where higher PL2 and PL4 powers are needed.

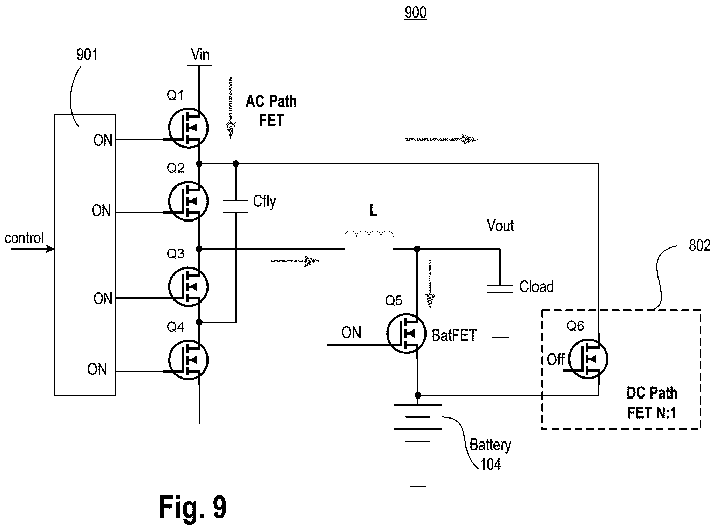

**Fig. 9** illustrates SCVR 900 during AC mode, in accordance to some embodiments. Most blocks of SCVR 900 are integrated in the charger circuit (e.g., embedded in hybrid charger 801). For example, converter comprising transistors Q1, Q2, Q3, and Q4 are part of hybrid charger 801. In various embodiments, the circuits or controller that control the drivers are implemented as controller 801a of hybrid charger 801. The control may control from a feedback operation that compares the output supply Vout with a reference and/or from ML DTT 103a and/or IC 102. Here, part of controller 801a is illustrated as control block 901 which sets the on/off conditions of converter FETs Q1, Q2, Q3, and Q4. As discussed with reference to **Figs. 4-5**, converter FETs Q1, Q2, Q3, and Q4 can be n-type, p-type, or a combination of them. In some embodiments, SCVR 900 comprises an inductor L coupled to an output of the converter FETs Q1, Q2, Q3, and Q4. Here, the output is the source terminal of transistor Q2 and the drain terminal of transistor Q3. The inductor can be integrated in hybrid charger 801 or can be a discrete component outside of hybrid charger 801. As one terminal of the inductor L is coupled to the output of the converter FETs Q1, Q2, Q3, and Q4, the other terminal of inductor L is coupled to the output load (e.g., load 106) and/or load capacitor Cload. The other terminal of inductor L is also coupled to BatFET Q5. In various embodiments, DC path FET 802 comprises transistor Q6 having a source terminal coupled to battery 104, and a drain terminal coupled to transistors Q1 and Q2 as shown. Note, for typical metal oxide semiconductor FETs, source and drain terminals have identical formation. Also note, Q5 and Q6 can be n-type, p-type or a combination of them. The hybrid SCVR charger implementation is described for with a 2:1 SCVR based 3-level converter but can be extended to any multi-level converter.

**Fig. 9** illustrates the AC mode of operation. In the AC mode, controller 901 turns on all SCVR converter FETs Q1, Q2, Q3, and Q4, turns on battery FET Q5, and turns of DC path FET Q6. In this case, SCVR charger 801 takes input voltage from the AC source, down converts to 4S voltage (based on the either traditional Type C or with EPR specification) and supplies power to battery 104 as well as system load 106. DC path FET Q6 is turned ON during DC mode and is kept OFF in AC mode, in accordance with various embodiments.

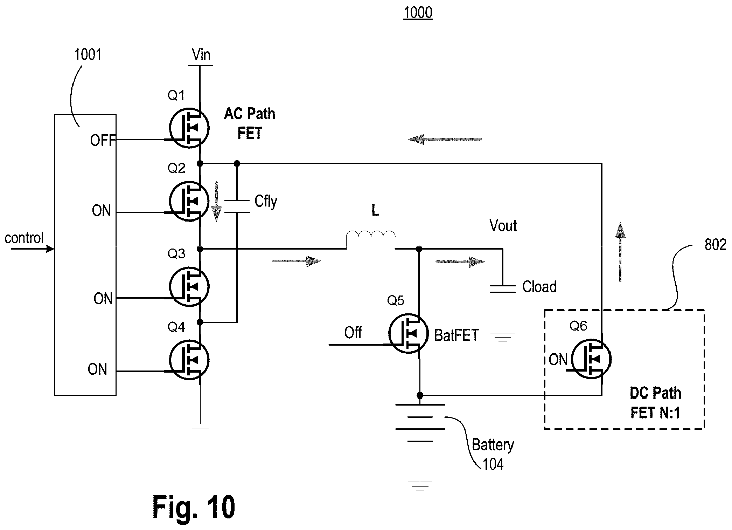

**Fig. 10** illustrates a portion of SCVR charger 1000 as voltage divider during DC mode, in accordance with some embodiments. The circuit topology of **Fig. 10** is same as that of **Fig. 9**, but for the configuration of the transistors. In this case, the voltage divider mode is a 2:1 mode (i.e., N=2). During DC mode, controller 1001 turns off transistor Q1 and battery FET Q5. It turns on SCVR converter transistors Q2, Q3, and Q4, and the DC path FET Q6. Charger 801 controls DC path FET 802 and works as a 2:1 converter along with other existing FETs. This mode is useful during light workloads and can sustain loads like video play back, Chrome browsing etc., where the system power requirement is low and VR efficiency is important. The efficiency in power conversion for the SCVR is greater than 98% in this case.

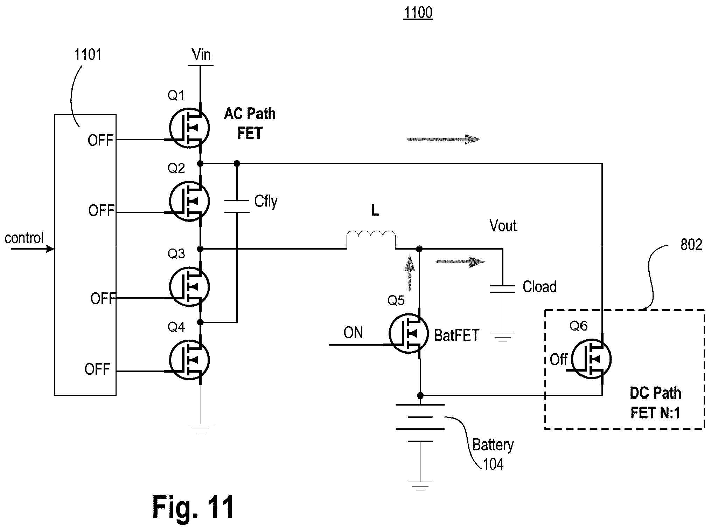

**Fig. 11** illustrates a portion of SCVR charger 1100 as voltage bypass mode during DC mode, in accordance with some embodiments. The circuit topology of **Fig. 11** is same as that of **Fig. 9**, but for the configuration of the transistors. **Fig. 11** shows the charger behavior during DC mode when operating in voltage bypass mode. In this mode, DC path FET 802 and the SCVR FETs Q1, Q2, Q3, and Q4 are turned OFF and the BatFET Q5 is turned ON. This battery path supplies 4S power directly to system load 106. So, the power available at the output Vout supply rail is higher thus supporting higher performance (due to the larger gap above Vsysmin) in comparison with the SCVR mode. The bypass mode is useful during performance mode, where the processor or system-on-chip (SoC) needs higher PL2 and PL4 powers.

In various embodiments, the criterial for selection between bypass mode or voltage divider mode is same as discussed with reference to **Figs. 1-7****.** For example, ML DTT 103a or IC 102 selects the voltage divider mode during light and battery-life workloads, and selects the bypass mode during turbo mode where higher PL2 and PL4 powers are needed. The idea of various embodiments can be extended to 2S to 1S conversion or 3S to 2S and any other voltage combination as the output generation involves a multi-level converter design. The embodiments here can be implemented without the inductor L. For example, if the assumption is of a PPS adaptor-based power or through a dock that is capable of type C PPS based power delivery is used, the inductor L can be removed. In some embodiments, bypass FET(s) can also be provided for the inductor L in case the loss through the inductor L is deemed unacceptable when operating with a PPS adaptor/dock supporting type C PPS based PD. The bypass FET can be controlled by controller 801a and when turned on will bypass the inductor L, in accordance with some embodiments.

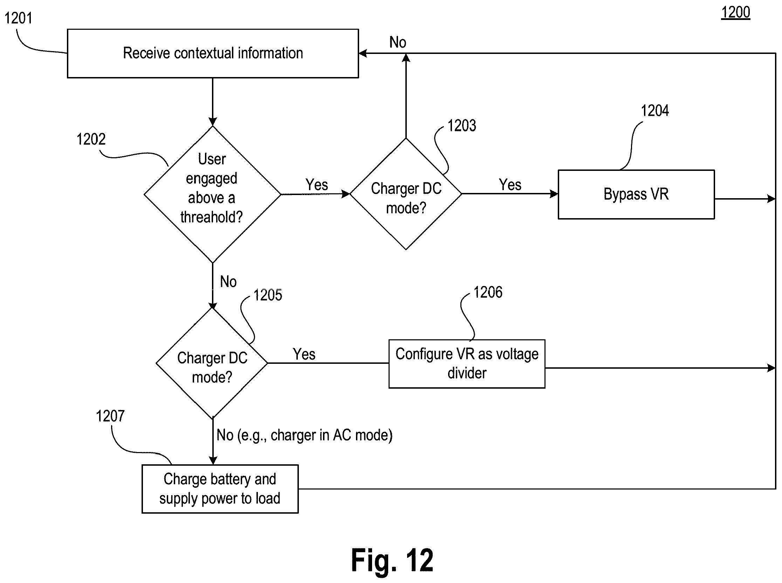

**Fig. 12** illustrates flowchart 1200 of a method for contextual usage of VR in a charger during DC mode to improve battery life and performance, in accordance with some embodiments. While the blocks are shown in a particular order, the order can be modified. For example, some blocks may be performed in parallel, while some blocks can be performed before others. The various blocks can be performed by software, hardware, or a combination of them.

At block 1201, SoC 103 (or any suitable logic) receives contextual information. The contextual information may include data about user attentiveness, user habit of using the device (e.g., a clamshell device), user eye movement data, usage of the clamshell device (e.g., whether it is being used for browsing the internet, reading an online book, gaming, etc.), time of the day, day of the week, etc. For instance, a user has a habit of using the clamshell device for browsing at night, working in the day, and off in the afternoon, and these habits are used to dynamically change the operation mode of SCVR of charger 801. In some embodiments, a machine-learning algorithm can be used to predict user behavior or classify user attentiveness as one of user engaged, less engaged, disengaged, or absent as indicated by block 1202. Based on the classification, SoC 103 (or any suitable logic) decides whether SCVR of charger 801 should be bypassed or entered in voltage divide mode. In various embodiments, operation mode of charger 801 is considered before the VR of charger 801 is placed in bypass mode or voltage divider mode. In some embodiments, SoC 103 (or any suitable logic) does not use machine-learning, but infers user attentiveness by comparing the attentiveness meta data to an overall threshold of activity. If a user engagement is above the threshold, the process proceeds to block 1203, otherwise the process proceeds to block 1205.

At block 1203, charger 801 and/or SoC 103 determines whether charger 801 is in DC mode. If charger 801 is in DC mode, the SCVR of charger 801 is bypassed at block 1204. The VR can be bypassed as described with reference to **Fig. 11****.** In some embodiments, a logic is provided which bypasses the voltage regulator based on the user attentiveness being determined to be inattentive or the user attentiveness is below a threshold. In some embodiments, the charger includes a power gate to bypass the voltage regulator in the bypass mode. This scheme can be similar to **Fig. 3** where power gate MN1 bypasses VR of charger 801 by electrically shorting Vin to Vout supply rails. The power gate scheme is different from configuring the drivers of SCVR, and can simplify the design of controller 801a.

Referring back to **Fig. 12**, the process can then proceed back to block 1201. If at block 1203, charger 801 and/or SoC 103 determines that charger 801 is not in DC mode (e.g., charger 801 is in AC mode), the battery 104 is charged and voltage is provided to system load, and the process proceeds to block 1201. At block 1205, charger 801 and/or SoC 103 determines whether charger 801 is in DC mode. In this case, user is less engaged, disengaged or absent. If charger 801 is in DC mode, the process proceeds to block 1206 where VR of charger 801 is configured in voltage divider mode as described with reference to Fig. 10. The process them proceeds to block 1201. If charger 801 is not in DC mode (e.g., charger 801 is in AC mode), the process proceeds to block 1207 where battery 104 is charged and load 106 is supplied with power as discussed with reference to **Fig. 9****.**

The change in operation mode of VR of charger 801 is dynamic or adaptive in that while the clamshell device is on, it may dynamically (in real-time) operate in bypass mode or voltage divider mode depending on user attentiveness, and/or AC mode or DC mode. As such, user receives high performance when user desires (e.g., when user is attentive) and longer battery life when user is inactive or less engaged (relative to a threshold).

Elements of embodiments are also provided as a machine-readable medium (e.g., memory) for storing the computer-executable instructions (e.g., instructions to implement any other processes discussed herein). In some embodiments, a computing platform comprises a memory, a processor, a machine-readable storage media (also referred to as tangible machine readable medium), a communication interface (e.g., wireless or wired interface), and a network bus coupling them.

In some embodiments, the processor is a Digital Signal Processor (DSP), an Application Specific Integrated Circuit (ASIC), a general-purpose Central Processing Unit (CPU), or a low power logic implementing a simple finite state machine to perform the method of various embodiments, etc.

In some embodiments, the various logic blocks of the system are coupled together via the network bus. Any suitable protocol may be used to implement the network bus. In some embodiments, the machine-readable storage medium includes instructions (also referred to as the program software code/instructions) for intelligent prediction of processor idle time as described with reference to the various embodiments and flowchart.

Program software code/instructions associated with flowchart(s) (and/or various embodiments) and executed to implement embodiments of the disclosed subject matter may be implemented as part of an operating system or a specific application, component, program, object, module, routine, or other sequence of instructions or organization of sequences of instructions referred to as "program software code/instructions," "operating system program software code/instructions," "application program software code/instructions," or simply "software" or firmware embedded in processor. In some embodiments, the program software code/instructions associated with flowchart 1200 (and/or various embodiments) are executed by the computer system.

In some embodiments, the program software code/instructions associated with flowchart 1200 (and/or various embodiments) are stored in a computer executable storage medium and executed by the processor. Here, computer executable storage medium is a tangible machine-readable medium that can be used to store program software code/instructions and data that, when executed by a computing device, causes one or more processors to perform a method(s) as may be recited in one or more accompanying claims directed to the disclosed subject matter.

The tangible machine-readable medium may include storage of the executable software program code/instructions and data in various tangible locations, including for example ROM, volatile RAM, non-volatile memory and/or cache and/or other tangible memory as referenced in the present application. Portions of this program software code/instructions and/or data may be stored in any one of these storage and memory devices. Further, the program software code/instructions can be obtained from other storage, including, e.g., through centralized servers or peer to peer networks and the like, including the Internet. Different portions of the software program code/instructions and data can be obtained at different times and in different communication sessions or in the same communication session.

The software program code/instructions (associated with flowchart 1200 and other embodiments) and data can be obtained in their entirety prior to the execution of a respective software program or application by the computing device. Alternatively, portions of the software program code/instructions and data can be obtained dynamically, e.g., just in time, when needed for execution. Alternatively, some combination of these ways of obtaining the software program code/instructions and data may occur, e.g., for different applications, components, programs, objects, modules, routines or other sequences of instructions or organization of sequences of instructions, by way of example. Thus, it is not required that the data and instructions be on a tangible machine readable medium in entirety at a particular instance of time.

Examples of tangible computer-readable media include but are not limited to recordable and non-recordable type media such as volatile and non-volatile memory devices, read only memory (ROM), random access memory (RAM), flash memory devices, magnetic random-access memory, ferroelectric memory, floppy and other removable disks, magnetic storage media, optical storage media (e.g., Compact Disk Read-Only Memory (CD ROMS), Digital Versatile Disks (DVDs), etc.), among others. The software program code/instructions may be temporarily stored in digital tangible communication links while implementing electrical, optical, acoustical or other forms of propagating signals, such as carrier waves, infrared signals, digital signals, etc. through such tangible communication links.

In general, the tangible machine readable medium includes any tangible mechanism that provides (i.e., stores and/or transmits in digital form, e.g., data packets) information in a form accessible by a machine (i.e., a computing device), which may be included, e.g., in a communication device, a computing device, a network device, a personal digital assistant, a manufacturing tool, a mobile communication device, whether or not able to download and run applications and subsidized applications from the communication network, such as the Internet, e.g., an iPhone^{®}, Galaxy^{®}, Blackberry^{®} Droid^{®}, or the like, or any other device including a computing device. In one embodiment, processor-based system is in a form of or included within a PDA (personal digital assistant), a cellular phone, a notebook computer, a tablet, a game console, a set top box, an embedded system, a TV (television), a personal desktop computer, etc. Alternatively, the traditional communication applications and subsidized application(s) may be used in some embodiments of the disclosed subject matter.

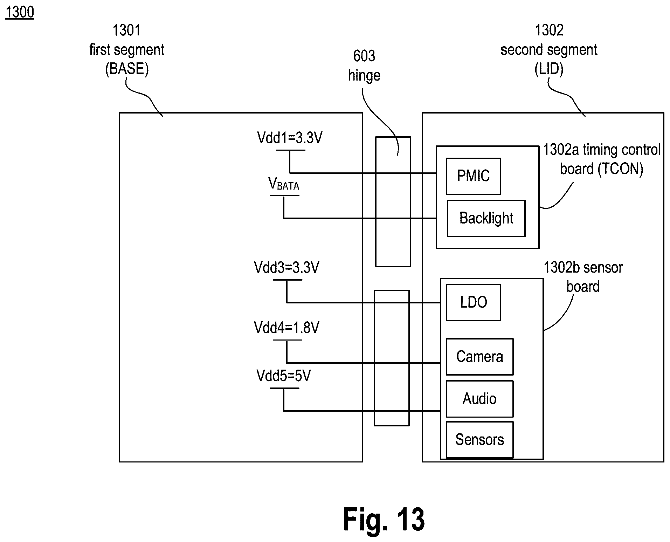

**Fig. 13** illustrates clamshell computing device 1300 where a base segment provides multiple power supply voltages to the lid segment. Clamshell computing device 1300 comprises first segment (BASE) 1301, second segment (LID) 1302 and hinge 603. First segment 1301 includes multiple power supply lines and sources or regulators that generate Vdd1 (e.g., 3.3V), Vdd3 (e.g., 3.3V), Vdd4 (e.g., 1.8V), Vdd5 (e.g., 5V), where V_{BATA} is the battery voltage (e.g., 3S, 4S voltages). These power supply lines pass through hinge(s) 603 that all hinge resistance to the supply lines resulting in IR drop at the second segment 1302. Second segment 1302 includes embedded components such as timing control board (TCON) 1302a and sensor board 1302b. TCON 1302a includes power management integrated circuit (PMIC), drivers for backlight display, etc. Sensor board 1302b includes a number of embedded sensors such as camera, audio mic, motion sensor, etc. In this example, a low dropout voltage regulator (LDO VR) on sensor board 1302b provides power to one or more components of sensor board 1302b. This architecture of power delivery from first segment 1301 to the second segment 1302 requires multiple power cables.

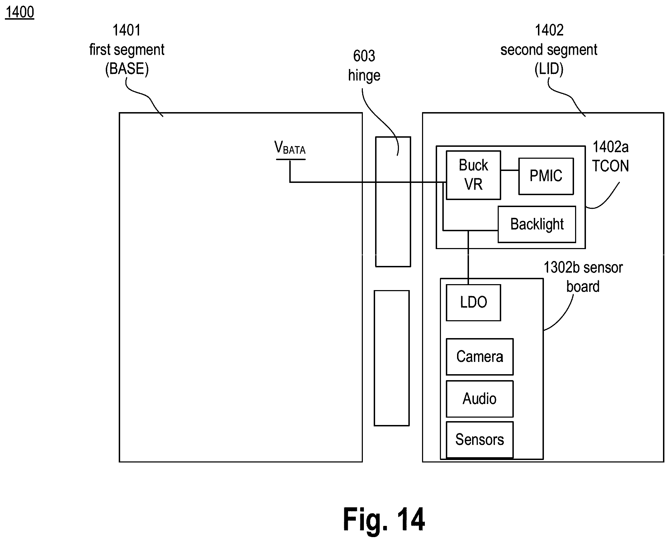

**Fig. 14** illustrates clamshell computing device 1400 where a single power supply line from one segment to another is used with dynamic VR conversion ratio to supply power in various modes to loads of the clamshell computing device, in accordance with some embodiments. In view of the lossy power delivery environment because of hinge 603, some embodiments provide a power delivery architecture to transfer power to second segment 1302 at a higher voltage (V_{BATA}) and then convert it to the required downstream power rails. Given the higher efficiency of conversion for the lower voltage rails with a lower input voltage, the power delivery architecture of some embodiments relies on an intermediate conversion stage (from V_{BATA} to 1S or 3.3V and then feed it to the downstream regulators. In some embodiments, power delivery architecture of first segment 1401 is simplified (compared to first segment 1301) by moving a buck VR to second segment 1402 (e.g., part of TCON 1402a), where the buck VR receives the higher voltage (V_{BATA}) and then down converts it to the required downstream power rails for various components of TCON and/or sensor board 1302a. As such, number of power supply lines passing from first segment 1401 to second segment 1402 are reduced.

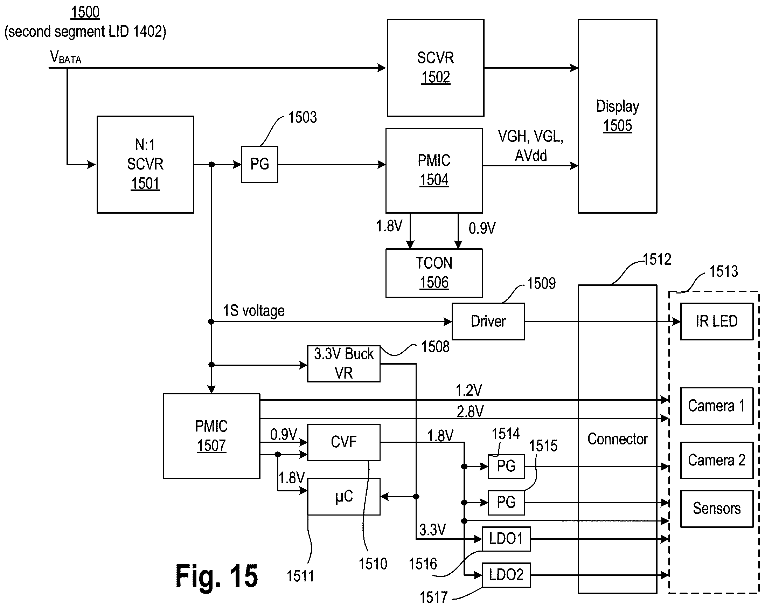

**Fig. 15** illustrates power delivery architecture 1500 that uses a single power supply line V_{BATA} from one segment of a clamshell computing device to generate multiple supplies for different loads for different contexts, in accordance with some embodiments. Power delivery architecture 1500 comprises N:1 VR 1501 (e.g., 3:1 SCVR). VR 1502, power gate (PG) 1503, PMIC 1504, display 1505, TCON 1506, PMIC 1507, Buck VR 1508, driver 1509, CVF 1510, microcontroller 1511, connector 1512, sensors and cameras 1513, PG 1514, PG 1515, LDO1 1516, and LDO2 1517. Traditionally, N:1 SCVR 1501 is a 3.3V buck converter for intermediate conversion. The 3.3V buck converter is a large circuit compared to the dynamically adjustable N:1 SCVR 1501 with adaptable conversional ratio. The : 1 SCVR 1501 feeds the downstream regulators and integrated circuits which can accept 1S voltage range. In some embodiments, a much smaller 3.3V buck regulator 1508 is used for loads that expect a regulated 3.3V supply.

Some embodiments provide a method and apparatus of ensuring the output voltage from the N:1 SCVR 1501 does not go below the input power supply Vin minimum requirements, irrespective of the battery state (either voltage droop due to heavy load and/or lower state-of-charge of battery). This is achieved by dynamically changing the SCVR conversion ratio N based on the battery voltage V_{BATA} and context of system usage (e.g., user attentiveness or usage which decides performance mode or efficient mode). For example, the scheme of some embodiments adaptively varies the conversion ratio of the V_{BATA} to the voltage to downstream VRs (e.g., SCVR 1502, buck VR 1508, LDO1 1516, LDO2 1517) based on the user context and/or workload being serviced by the processor.

In some embodiments, the operation of SCVR 1501 is dynamically modified to a lower conversion ratio (e.g., 2:1 in lieu of 3:1) during at least two events. The first event is a high-performance state (as determined by context, workload information) that is expected to cause a drop or droop on the battery voltage, and such a droop may reflect on the SCVR output that can hurt the Lid side power integrity. The second event is lower state-of-charge of the battery. Lowering the conversion ratio N benefits from the higher efficiency in conversion with an SCVR implementation (in comparison with direct conversion) till the cutoff point of the battery while not spending on expensive power conversion parts.

As such, higher conversion efficiency is achieved even at lower state-of-charge of the battery (in comparison with direct conversion). The scheme avoids system failures at lower state-of-charge of the battery during interactive/ or high-performance mode of operation. The scheme results in minimal to no additional cost incurred in implementation given that the switched capacitor power converter is already capable of lower conversion ratios. As such, no energy from the battery is left unutilized.

In some embodiments, 1502 is an SCVR based backlight driver chip. In some embodiments, 1503 is a power gate in the design that can be used to save power in specific scenarios where the display can be turned off. In some embodiments, 1504 is a display bias voltage generation Power management Integrated Circuit (PMIC) that takes the output of N:1 SCVR converter 1501 and generates the required bias voltages for the source/gate drive. In some embodiments, 1505 is a display panel such as Electroluminescent (ELD) display, Liquid crystal display (LCD), Light-emitting diode (LED) backlit LCD, Thin-film transistor (TFT) LCD, Light-emitting diode (LED) display, Organic LED display, Active Matrix Organic LED (AMOLED) display, Plasma (PDP) display, and/or Quantum dot (QLED) display. In some embodiments, 1506 is a TCON (timing controller). In some embodiments, 1507 is a PMIC for the Vision Compute chip, sensors and micro-controller. In some embodiments, 1508 is a tiny buck regulator that supplies to regulated voltage to the loads that may not accept a wide range of voltages. In some embodiments, 1509 is an Infrared (IR) flash LED driver for an IR sensor. In some embodiments, 1510 is a Vision compute chip. In some embodiments, 1511 is a tiny micro-controller that holds some glue logic, communication, and control logic. In some embodiments, 1512 is a connector that interfaces to a sensor board. In some embodiments, 1513 is the sensor board comprising cameras, sensors, and IR LED. In some embodiments, 1514, 1515 are Power Gates (PGs) in place to meet the power sequencing requirements of some of the sensors and to turn the power off when not required.

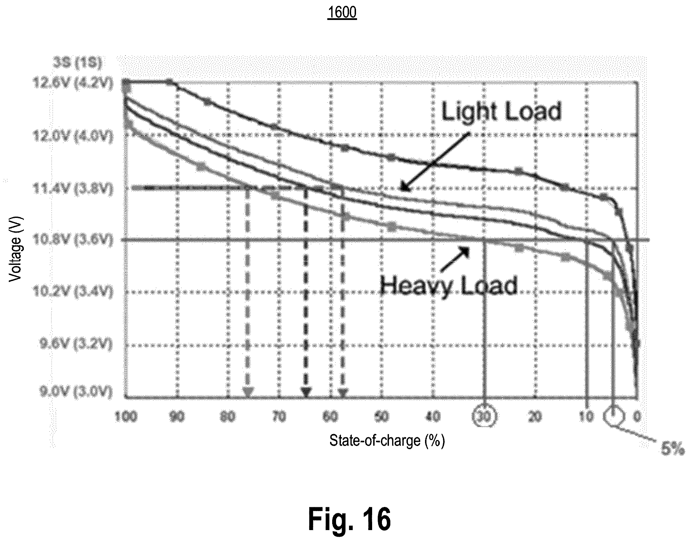

**Fig. 16** illustrates plot 1600 showing voltage variation at the output of a voltage regulator with dynamic voltage conversion, in accordance with some embodiments. Here, x-axis is state-of-charge of battery 104 in percentage, while y-axis is output of SCVR 1501. Line and load regulation data for a typical 3.3V tiny buck regulator shows that for an input less than or equal to 3.6V, the output cannot be regulated. Hence, the Vmin for input of 3.3V regulator is 3.6V. However, the SCVR output depends on the battery voltage. So, the 3.3V regulator should get an input which is greater than 3.6V irrespective of the battery load or state-of-charge. Plot 1600 shows the variation in the battery voltage (assumed here as 3S) based on different loading conditions and state-of-charge.

Heavy load scenarios can bring down the V_{BATA} voltage as low as 10.8V at 30% state-of-charge, thus output of the 3:1 SCVR 1501 can go as low as 3.6V. If the conversion ratio N is fixed at 3:1, then the remaining juice in the battery (e.g., approximately 30%) may not be utilized as the Lid components may not be powered due to Vmin violation of 3.3V regulator 1508. During light load scenarios, the V_{BATA} voltage remains around 10.8V even at 5% state-of-charge.

Since the battery voltage V_{BATA} is a function of two parameters with respect to loading and state-of-charge, SCVR 1501 is used in an innovative way by switching the conversion ratios based on the battery voltage, in accordance with some embodiments. Changing the conversion ratio helps to provide an appropriate output of SCVR greater than Vmin of 3.3V regulator input, thus the Lid components are functional even at lower state-of-charge (e.g., approximately 5%).

Architecture of **Fig. 1** is also applicable for dynamic adjustment of SCVR conversion ratio. In some embodiments, real-time loading on battery 104 can be determined by ML DTT framework 103a which is linked with IC 102 (e.g., Low power Vision Companion chip) to get the user attentiveness data. Based on the user attentiveness data, ML DTT framework 103a can map the different modes of operations like: Interactive Mode (High Performance- High load on battery), Efficient Mode (Power Efficient - Low load on battery), Quiet Mode, and Standby Mode. In some embodiments, ML DTT framework 103a monitors the real-time state-of-charge of battery 104. For example, ML DTT framework 103a may use Dynamic Battery Power Technology (DBPT) algorithm by Intel Corporation to monitor real-time state-of-charge of battery 104. In other examples, state-of-charge of battery 104 can be obtained from a fuel gauge of battery 104.

With the data of battery loading and state-of-charge, the decision to switch the conversion ratio of SCVR can be taken by the ML DTT framework 103a, in accordance with various embodiments. As an example, consider a 3S battery, in a heavy load condition with a state-of-charge of approximately 30%. Here, the battery voltage V_{BATA} is 10.8V and the output of the 3:1 SCVR can be as low as 3.6V. In this case, ML DTT framework 103a can command SCVR 1501 to shift the conversion ratio to 2:1 such that SCVR output 1501 becomes 5.4V thereby extending the operation till the lower state-of-charge of battery 104 and ensuring there are no functional failures. With reference to **Fig. 1**, block 105 can be re-labeled as SCVR 1501. In some embodiments, SCVR 1501 has a programmable threshold that compares the output against and dynamically changes the conversion ratio when the output drops below the threshold. The threshold can have some hysteresis built in to prevent chattering, in accordance with some embodiments.

Table 3 shows the choice of SCVR conversion ratio based on user attentiveness and battery state-of-charge. In some embodiments, ML DTT framework 103 a puts SCVR 1501 in 2:1 during interactive mode to supply proper voltages (during turbo events) when the state-of-charge is lower and in all other modes ML DTT framework 103a selects the 3:1 conversion ratio which is the most efficient.

**Table 3**

| **Battery RSoC** | **User Attentiveness mode** | **Turbo mode** | **SCVR mode** |
|---|---|---|---|
| Greater than x% | Interactive | Enabled | 3:1 Conversion |
| | Efficient | Disabled | 3:1 Conversion |
| | Quiet | Disabled | 3:1 Conversion |
| | Standby | Disabled | 3:1 Conversion |
| Less than x% | **Interactive** | **Enabled** | **2:1 Conversion** |
| | Efficient | Disabled | 3:1 Conversion |
| | Quiet | Disabled | 3:1 Conversion |
| | Standby | Disabled | 3:1 Conversion |

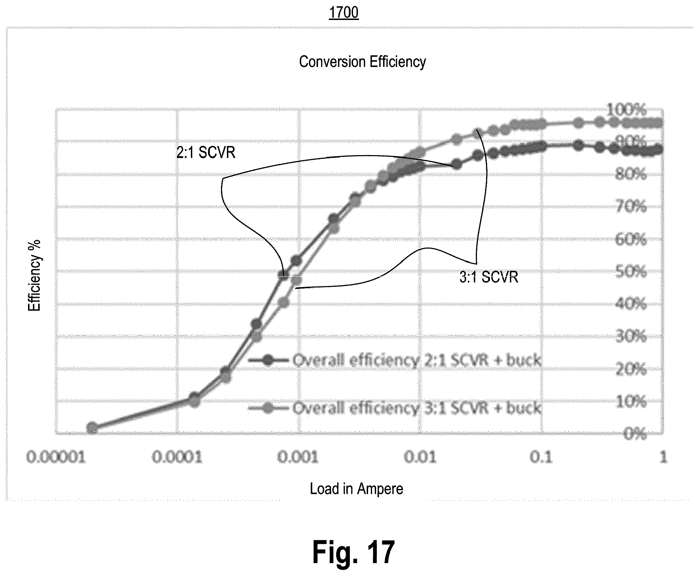

**Fig. 17** illustrates plot 1700 showing efficiency in 3.3V power generation when the input voltage changes from 3.6V (3:1) to 5.4V (2:1), in accordance with some embodiments. Here, x-axis is load in Ampere and y-axis is conversion efficiency in percentage for SCVR 1501. Plot 1700 shows the comparison in the overall efficiency in conversion from the battery voltage to the 3.3V output. Note, that the efficiency during 2:1 conversion ratio is below that of the 3:1. This short-term lossy behavior though is a small cost to avoid any functional failures (due to Vin Min violation for 3.3V regulator) and unexpected marginality issues like display artifacts or display flicker, camera and companion chip malfunctioning, Windows Hello detection failure, sensors and audio malfunctions etc.

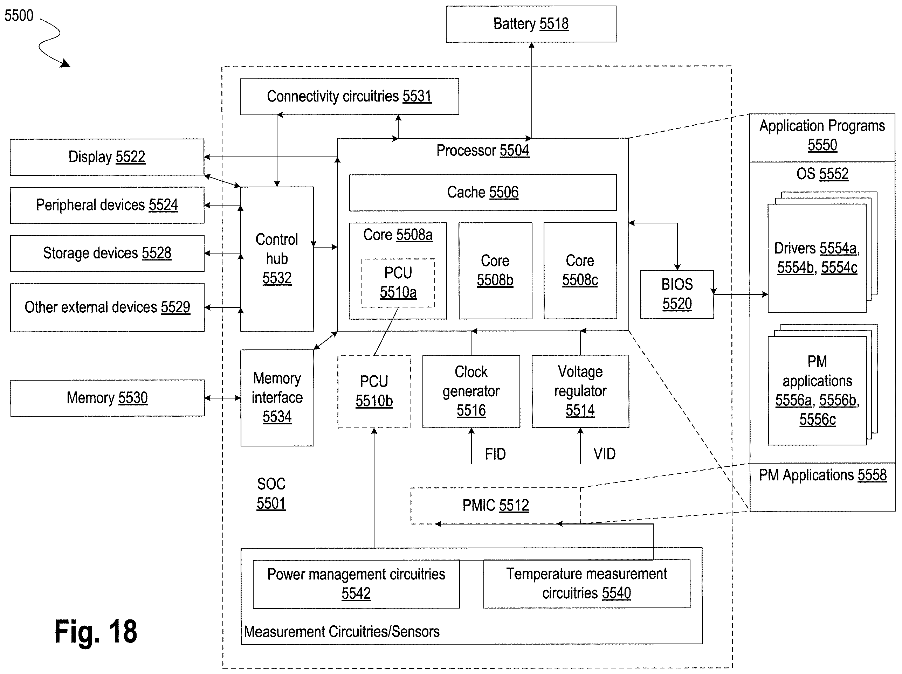

**Fig. 18** illustrates a system-on-chip (SoC), a smart device, or a computer system with apparatus for contextual input voltage selection for optimal power delivery, in accordance with some embodiments. It is pointed out that those elements of Fig. 18 having the same reference numbers (or names) as the elements of any other figure may operate or function in any manner similar to that described, but are not limited to such. Any block in this smart device can have the apparatus for contextual input voltage selection for optimal power delivery, in accordance with some embodiments.

In some embodiments, device 5500 represents an appropriate computing device, such as a computing tablet, a mobile phone or smart-phone, a laptop, a desktop, an Internet-of-Things (IOT) device, a server, a wearable device, a set-top box, a wireless-enabled e-reader, or the like. It will be understood that certain components are shown generally, and not all components of such a device are shown in device 5500.

In an example, the device 5500 comprises an SoC (System-on-Chip) 5501. An example boundary of the SoC 5501 is illustrated using dotted lines in **Fig. 18**, with some example components being illustrated to be included within SoC 5501 - however, SoC 5501 may include any appropriate components of device 5500.

In some embodiments, device 5500 includes processor 5504. Processor 5504 can include one or more physical devices, such as microprocessors, application processors, microcontrollers, programmable logic devices, processing cores, or other processing implementations such as disaggregated combinations of multiple compute, graphics, accelerator, I/O and/or other processing chips. The processing operations performed by processor 5504 include the execution of an operating platform or operating system on which applications and/or device functions are executed. The processing operations include operations related to I/O (input/output) with a human user or with other devices, operations related to power management, operations related to connecting computing device 5500 to another device, and/or the like. The processing operations may also include operations related to audio I/O and/or display I/O.

In some embodiments, processor 5504 includes multiple processing cores (also referred to as cores) 5508a, 5508b, 5508c. Although merely three cores 5508a, 5508b, 5508c are illustrated in **Fig. 18**, processor 5504 may include any other appropriate number of processing cores, e.g., tens, or even hundreds of processing cores. Processor cores 5508a, 5508b, 5508c may be implemented on a single integrated circuit (IC) chip. Moreover, the chip may include one or more shared and/or private caches, buses or interconnections, graphics and/or memory controllers, or other components.

In some embodiments, processor 5504 includes cache 5506. In an example, sections of cache 5506 may be dedicated to individual cores 5508 (e.g., a first section of cache 5506 dedicated to core 5508a, a second section of cache 5506 dedicated to core 5508b, and so on). In an example, one or more sections of cache 5506 may be shared among two or more of cores 5508. Cache 5506 may be split in different levels, e.g., level 1 (L1) cache, level 2 (L2) cache, level 3 (L3) cache, etc.

In some embodiments, processor core 5504 may include a fetch unit to fetch instructions (including instructions with conditional branches) for execution by the core 5504. The instructions may be fetched from any storage devices such as the memory 5530. Processor core 5504 may also include a decode unit to decode the fetched instruction. For example, the decode unit may decode the fetched instruction into a plurality of micro-operations. Processor core 5504 may include a schedule unit to perform various operations associated with storing decoded instructions. For example, the schedule unit may hold data from the decode unit until the instructions are ready for dispatch, e.g., until all source values of a decoded instruction become available. In one embodiment, the schedule unit may schedule and/or issue (or dispatch) decoded instructions to an execution unit for execution.

The execution unit may execute the dispatched instructions after they are decoded (e.g., by the decode unit) and dispatched (e.g., by the schedule unit). In an embodiment, the execution unit may include more than one execution unit (such as an imaging computational unit, a graphics computational unit, a general-purpose computational unit, etc.). The execution unit may also perform various arithmetic operations such as addition, subtraction, multiplication, and/or division, and may include one or more arithmetic logic units (ALUs). In an embodiment, a co-processor (not shown) may perform various arithmetic operations in conjunction with the execution unit.

Further, execution unit may execute instructions out-of-order. Hence, processor core 5504 may be an out-of-order processor core in one embodiment. Processor core 5504 may also include a retirement unit. The retirement unit may retire executed instructions after they are committed. In an embodiment, retirement of the executed instructions may result in processor state being committed from the execution of the instructions, physical registers used by the instructions being de-allocated, etc. Processor core 5504 may also include a bus unit to enable communication between components of processor core 5504 and other components via one or more buses. Processor core 5504 may also include one or more registers to store data accessed by various components of the core 5504 (such as values related to assigned app priorities and/or sub-system states (modes) association.

In some embodiments, device 5500 comprises connectivity circuitries 5531. For example, connectivity circuitries 5531 includes hardware devices (e.g., wireless and/or wired connectors and communication hardware) and/or software components (e.g., drivers, protocol stacks), e.g., to enable device 5500 to communicate with external devices. Device 5500 may be separate from the external devices, such as other computing devices, wireless access points or base stations, etc.

In an example, connectivity circuitries 5531 may include multiple different types of connectivity. To generalize, the connectivity circuitries 5531 may include cellular connectivity circuitries, wireless connectivity circuitries, etc. Cellular connectivity circuitries of connectivity circuitries 5531 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, 3rd Generation Partnership Project (3GPP) Universal Mobile Telecommunications Systems (UMTS) system or variations or derivatives, 3GPP Long-Term Evolution (LTE) system or variations or derivatives, 3GPP LTE-Advanced (LTE-A) system or variations or derivatives, Fifth Generation (5G) wireless system or variations or derivatives, 5G mobile networks system or variations or derivatives, 5G New Radio (NR) system or variations or derivatives, or other cellular service standards. Wireless connectivity circuitries (or wireless interface) of the connectivity circuitries 5531 refers to wireless connectivity that is not cellular, and can include personal area networks (such as Bluetooth, Near Field, etc.), local area networks (such as Wi-Fi), and/or wide area networks (such as WiMax), and/or other wireless communication. In an example, connectivity circuitries 5531 may include a network interface, such as a wired or wireless interface, e.g., so that a system embodiment may be incorporated into a wireless device, for example, a cell phone or personal digital assistant.

In some embodiments, device 5500 comprises control hub 5532, which represents hardware devices and/or software components related to interaction with one or more I/O devices. For example, processor 5504 may communicate with one or more of display 5522, one or more peripheral devices 5524, storage devices 5528, one or more other external devices 5529, etc., via control hub 5532. Control hub 5532 may be a chipset, a Platform Control Hub (PCH), and/or the like.

For example, control hub 5532 illustrates one or more connection points for additional devices that connect to device 5500, e.g., through which a user might interact with the system. For example, devices (e.g., devices 5529) that can be attached to device 5500 include microphone devices, speaker or stereo systems, audio devices, video systems or other display devices, keyboard or keypad devices, or other I/O devices for use with specific applications such as card readers or other devices.

As mentioned above, control hub 5532 can interact with audio devices, display 5522, etc. For example, input through a microphone or other audio device can provide input or commands for one or more applications or functions of device 5500. Additionally, audio output can be provided instead of, or in addition to display output. In another example, if display 5522 includes a touch screen, display 5522 also acts as an input device, which can be at least partially managed by control hub 5532. There can also be additional buttons or switches on computing device 5500 to provide I/O functions managed by control hub 5532. In one embodiment, control hub 5532 manages devices such as accelerometers, cameras, light sensors or other environmental sensors, or other hardware that can be included in device 5500. The input can be part of direct user interaction, as well as providing environmental input to the system to influence its operations (such as filtering for noise, adjusting displays for brightness detection, applying a flash for a camera, or other features).

In some embodiments, control hub 5532 may couple to various devices using any appropriate communication protocol, e.g., PCIe (Peripheral Component Interconnect Express), USB (Universal Serial Bus), Thunderbolt, High Definition Multimedia Interface (HDMI), Firewire, etc.

In some embodiments, display 5522 represents hardware (e.g., display devices) and software (e.g., drivers) components that provide a visual and/or tactile display for a user to interact with device 5500. Display 5522 may include a display interface, a display screen, and/or hardware device used to provide a display to a user. In some embodiments, display 5522 includes a touch screen (or touch pad) device that provides both output and input to a user. In an example, display 5522 may communicate directly with the processor 5504. Display 5522 can be one or more of an internal display device, as in a mobile electronic device or a laptop device or an external display device attached via a display interface (e.g., DisplayPort, etc.). In one embodiment display 5522 can be a head mounted display (HMD) such as a stereoscopic display device for use in virtual reality (VR) applications or augmented reality (AR) applications.

In some embodiments, and although not illustrated in the figure, in addition to (or instead of) processor 5504, device 5500 may include Graphics Processing Unit (GPU) comprising one or more graphics processing cores, which may control one or more aspects of displaying contents on display 5522.

Control hub 5532 (or platform controller hub) may include hardware interfaces and connectors, as well as software components (e.g., drivers, protocol stacks) to make peripheral connections, e.g., to peripheral devices 5524.

It will be understood that device 5500 could both be a peripheral device to other computing devices, as well as have peripheral devices connected to it. Device 5500 may have a "docking" connector to connect to other computing devices for purposes such as managing (e.g., downloading and/or uploading, changing, synchronizing) content on device 5500. Additionally, a docking connector can allow device 5500 to connect to certain peripherals that allow computing device 5500 to control content output, for example, to audiovisual or other systems.

In addition to a proprietary docking connector or other proprietary connection hardware, device 5500 can make peripheral connections via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

In some embodiments, connectivity circuitries 5531 may be coupled to control hub 5532, e.g., in addition to, or instead of, being coupled directly to the processor 5504. In some embodiments, display 5522 may be coupled to control hub 5532, e.g., in addition to, or instead of, being coupled directly to processor 5504.

In some embodiments, device 5500 comprises memory 5530 coupled to processor 5504 via memory interface 5534. Memory 5530 includes memory devices for storing information in device 5500.

In some embodiments, memory 5530 includes apparatus to maintain stable clocking as described with reference to various embodiments. Memory can include nonvolatile (state does not change if power to the memory device is interrupted) and/or volatile (state is indeterminate if power to the memory device is interrupted) memory devices. Memory device 5530 can be a dynamic random-access memory (DRAM) device, a static random-access memory (SRAM) device, flash memory device, phase-change memory device, or some other memory device having suitable performance to serve as process memory. In one embodiment, memory 5530 can operate as system memory for device 5500, to store data and instructions for use when the one or more processors 5504 executes an application or process. Memory 5530 can store application data, user data, music, photos, documents, or other data, as well as system data (whether long-term or temporary) related to the execution of the applications and functions of device 5500.

Elements of various embodiments and examples are also provided as a machine-readable medium (e.g., memory 5530) for storing the computer-executable instructions (e.g., instructions to implement any other processes discussed herein). The machine-readable medium (e.g., memory 5530) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

In some embodiments, device 5500 comprises temperature measurement circuitries 5540, e.g., for measuring temperature of various components of device 5500. In an example, temperature measurement circuitries 5540 may be embedded, or coupled or attached to various components, whose temperature are to be measured and monitored. For example, temperature measurement circuitries 5540 may measure temperature of (or within) one or more of cores 5508a, 5508b, 5508c, voltage regulator 5514, memory 5530, a mother-board of SoC 5501, and/or any appropriate component of device 5500. In some embodiments, temperature measurement circuitries 5540 include a low power hybrid reverse (LPHR) bandgap reference (BGR) and digital temperature sensor (DTS), which utilizes subthreshold metal oxide semiconductor (MOS) transistor and the PNP parasitic Bi-polar Junction Transistor (BJT) device to form a reverse BGR that serves as the base for configurable BGR or DTS operating modes. The LPHR architecture uses low-cost MOS transistors and the standard parasitic PNP device. Based on a reverse bandgap voltage, the LPHR can work as a configurable BGR. By comparing the configurable BGR with the scaled base-emitter voltage, the circuit can also perform as a DTS with a linear transfer function with single-temperature trim for high accuracy.

In some embodiments, device 5500 comprises power measurement circuitries 5542, e.g., for measuring power consumed by one or more components of the device 5500. In an example, in addition to, or instead of, measuring power, the power measurement circuitries 5542 may measure voltage and/or current. In an example, the power measurement circuitries 5542 may be embedded, or coupled or attached to various components, whose power, voltage, and/or current consumption are to be measured and monitored. For example, power measurement circuitries 5542 may measure power, current and/or voltage supplied by one or more voltage regulators 5514, power supplied to SoC 5501, power supplied to device 5500, power consumed by processor 5504 (or any other component) of device 5500, etc.

In some embodiments, device 5500 comprises one or more voltage regulator circuitries, generally referred to as voltage regulator (VR) 5514. VR 5514 generates signals at appropriate voltage levels, which may be supplied to operate any appropriate components of the device 5500. Merely as an example, VR 5514 is illustrated to be supplying signals to processor 5504 of device 5500. In some embodiments, VR 5514 receives one or more Voltage Identification (VID) signals, and generates the voltage signal at an appropriate level, based on the VID signals. Various type of VRs may be utilized for the VR 5514. For example, VR 5514 may include a "buck" VR, "boost" VR, a combination of buck and boost VRs, low dropout (LDO) regulators, switching DC-DC regulators, constant-on-time controller-based DC-DC regulator, etc. Buck VR is generally used in power delivery applications in which an input voltage needs to be transformed to an output voltage in a ratio that is smaller than unity. Boost VR is generally used in power delivery applications in which an input voltage needs to be transformed to an output voltage in a ratio that is larger than unity. In some embodiments, each processor core has its own VR, which is controlled by PCU 5510a/b and/or PMIC 5512. In some embodiments, each core has a network of distributed LDOs to provide efficient control for power management. The LDOs can be digital, analog, or a combination of digital or analog LDOs. In some embodiments, VR 5514 includes current tracking apparatus to measure current through power supply rail(s).

In some embodiments, VR 5514 includes a digital control scheme to manage states of a proportional-integral-derivative (PID) filter (also known as a digital Type-III compensator). The digital control scheme controls the integrator of the PID filter to implement non-linear control of saturating the duty cycle during which the proportional and derivative terms of the PID are set to 0 while the integrator and its internal states (previous values or memory) is set to a duty cycle that is the sum of the current nominal duty cycle plus a deltaD. The deltaD is the maximum duty cycle increment that is used to regulate a voltage regulator from ICCmin to ICCmax and is a configuration register that can be set post silicon. A state machine moves from a non-linear all ON state (which brings the output voltage Vout back to a regulation window) to an open loop duty cycle which maintains the output voltage slightly higher than the required reference voltage Vref. After a certain period in this state of open loop at the commanded duty cycle, the state machine then ramps down the open loop duty cycle value until the output voltage is close to the Vref commanded. As such, output chatter on the output supply from VR 5514 is completely eliminated (or substantially eliminated) and there is merely a single undershoot transition which could lead to a guaranteed Vmin based on a comparator delay and the di/dt of the load with the available output decoupling capacitance.

In some embodiments, VR 5514 includes a separate self-start controller, which is functional without fuse and/or trim information. The self-start controller protects VR 5514 against large inrush currents and voltage overshoots, while being capable of following a variable VID (voltage identification) reference ramp imposed by the system. In some embodiments, the self-start controller uses a relaxation oscillator built into the controller to set the switching frequency of the buck converter. The oscillator can be initialized using either a clock or current reference to be close to a desired operating frequency. The output of VR 5514 is coupled weakly to the oscillator to set the duty cycle for closed loop operation. The controller is naturally biased such that the output voltage is always slightly higher than the set point, eliminating the need for any process, voltage, and/or temperature (PVT) imposed trims.

In some embodiments, device 5500 comprises one or more clock generator circuitries, generally referred to as clock generator 5516. Clock generator 5516 generates clock signals at appropriate frequency levels, which may be supplied to any appropriate components of device 5500. Merely as an example, clock generator 5516 is illustrated to be supplying clock signals to processor 5504 of device 5500. In some embodiments, clock generator 5516 receives one or more Frequency Identification (FID) signals, and generates the clock signals at an appropriate frequency, based on the FID signals.

In some embodiments, device 5500 comprises battery 5518 supplying power to various components of device 5500. Merely as an example, battery 5518 is illustrated to be supplying power to processor 5504. Although not illustrated in the figures, device 5500 may comprise a charging circuitry, e.g., to recharge the battery, based on Alternating Current (AC) power supply received from an AC adapter.

In some embodiments, battery 5518 periodically checks an actual battery capacity or energy with charge to a preset voltage (e.g., 4.1 V). The battery then decides of the battery capacity or energy. If the capacity or energy is insufficient, then an apparatus in or associated with the battery slightly increases charging voltage to a point where the capacity is sufficient (e.g. from 4.1 V to 4.11 V). The process of periodically checking and slightly increase charging voltage is performed until charging voltage reaches specification limit (e.g., 4.2 V). The scheme described herein has benefits such as battery longevity can be extended, risk of insufficient energy reserve can be reduced, burst power can be used as long as possible, and/or even higher burst power can be used.

In some embodiments, battery 5518 is a multi-battery system with workload dependent load-sharing mechanism. The mechanism is an energy management system that operates in three modes-energy saving mode, balancer mode, and turbo mode. The energy saving mode is a normal mode where the multiple batteries (collectively shown as battery 5518) provide power to their own set of loads with least resistive dissipation. In balancing mode, the batteries are connected through switches operating in active mode so that the current shared is inversely proportion to the corresponding battery state-of-charge. In turbo mode, both batteries are connected in parallel through switches (e.g., on-switches) to provide maximum power to a processor or load. In some embodiments, battery 5518 is a hybrid battery which comprising a fast charging battery and a high energy density battery. Fast charging battery (FC) means a battery capable of faster charging than high energy density battery (HE). FC may be today's Li-ion battery as it is capable of faster charging than HE. In some embodiments, a controller (part of battery 5518) optimizes the sequence and charging rate for the hybrid battery to maximize both the charging current and charging speed of the battery, while enabling longer battery life.

In some embodiments, the charging circuitry (e.g., 5518) comprises a buck-boost converter. This buck-boost converter comprises DrMOS or DrGaN devices used in place of half-bridges for traditional buck-boost converters. Various embodiments here are described with reference to DrMOS. However, the embodiments are applicable to DrGaN. The DrMOS devices allow for better efficiency in power conversion due to reduced parasitic and optimized MOSFET packaging. Since the dead-time management is internal to the DrMOS, the dead-time management is more accurate than for traditional buck-boost converters leading to higher efficiency in conversion. Higher frequency of operation allows for smaller inductor size, which in turn reduces the z-height of the charger comprising the DrMOS based buck-boost converter. The buck-boost converter of various embodiments comprises dual-folded bootstrap for DrMOS devices. In some embodiments, in addition to the traditional bootstrap capacitors, folded bootstrap capacitors are added that cross-couple inductor nodes to the two sets of DrMOS switches.

In some embodiments, device 5500 comprises Power Control Unit (PCU) 5510 (also referred to as Power Management Unit (PMU), Power Management Controller (PMC), Power Unit (p-unit), etc.). In an example, some sections of PCU 5510 may be implemented by one or more processing cores 5508, and these sections of PCU 5510 are symbolically illustrated using a dotted box and labelled PCU 5510a. In an example, some other sections of PCU 5510 may be implemented outside the processing cores 5508, and these sections of PCU 5510 are symbolically illustrated using a dotted box and labelled as PCU 5510b. PCU 5510 may implement various power management operations for device 5500. PCU 5510 may include hardware interfaces, hardware circuitries, connectors, registers, etc., as well as software components (e.g., drivers, protocol stacks), to implement various power management operations for device 5500.

In various embodiments, PCU or PMU 5510 is organized in a hierarchical manner forming a hierarchical power management (HPM). HPM of various embodiments builds a capability and infrastructure that allows for package level management for the platform, while still catering to islands of autonomy that might exist across the constituent die in the package. HPM does not assume a pre-determined mapping of physical partitions to domains. An HPM domain can be aligned with a function integrated inside a dielet, to a dielet boundary, to one or more dielets, to a companion die, or even a discrete CXL device. HPM addresses integration of multiple instances of the same die, mixed with proprietary functions or 3rd party functions integrated on the same die or separate die, and even accelerators connected via CXL (e.g., Flexbus) that may be inside the package, or in a discrete form factor.

HPM enables designers to meet the goals of scalability, modularity, and late binding. HPM also allows PMU functions that may already exist on other dice to be leveraged, instead of being disabled in the flat scheme. HPM enables management of any arbitrary collection of functions independent of their level of integration. HPM of various embodiments is scalable, modular, works with symmetric multi-chip processors (MCPs), and works with asymmetric MCPs. For example, HPM does not need a signal PM controller and package infrastructure to grow beyond reasonable scaling limits. HPM enables late addition of a die in a package without the need for change in the base die infrastructure. HPM addresses the need of disaggregated solutions having dies of different process technology nodes coupled in a single package. HPM also addresses the needs of companion die integration solutions-on and off package.

In various embodiments, each die (or dielet) includes a power management unit (PMU) or p-unit. For example, processor dies can have a supervisor p-unit, supervisee p-unit, or a dual role supervisor/supervisee p-unit. In some embodiments, an I/O die has its own dual role p-unit such as supervisor and/or supervisee p-unit. The p-units in each die can be instances of a generic p-unit. In one such example, all p-units have the same capability and circuits, but are configured (dynamically or statically) to take a role of a supervisor, supervisee, and/or both. In some embodiments, the p-units for compute dies are instances of a compute p-unit while p-units for IO dies are instances of an IO p-unit different from the compute p-unit. Depending on the role, p-unit acquires specific responsibilities to manage power of the multichip module and/or computing platform. While various p-units are described for dies in a multichip module or system-on-chip, a p-unit can also be part of an external device such as I/O device.

Here, the various p-units do not have to be the same. The HPM architecture can operate very different types of p-units. One common feature for the p-units is that they are expected to receive HPM messages and are expected to be able to comprehend them. In some embodiments, the p-unit of IO dies may be different than the p-unit of the compute dies. For example, the number of register instances of each class of register in the IO p-unit is different than those in the p-units of the compute dies. An IO die has the capability of being an HPM supervisor for CXL connected devices, but compute die may not need to have that capability. The IO and computes dice also have different firmware flows and possibly different firmware images. These are choices that an implementation can make. An HPM architecture can choose to have one superset firmware image and selectively execute flows that are relevant to the die type the firmware is associated with. Alternatively, there can be a customer firmware for each p-unit type; it can allow for more streamlined sizing of the firmware storage requirements for each p-unit type.

The p-unit in each die can be configured as a supervisor p-unit, supervisee p-unit or with a dual role of supervisor/supervisee. As such, p-units can perform roles of supervisor or supervisee for various domains. In various embodiments, each instance of p-unit is capable of autonomously managing local dedicated resources and contains structures to aggregate data and communicate between instances to enable shared resource management by the instance configured as the shared resource supervisor. A message and wire-based infrastructure is provided that can be duplicated and configured to facilitate management and flows between multiple p-units.

In some embodiments, power and thermal thresholds are communicated by a supervisor p-unit to supervisee p-units. For example, a supervisor p-unit learns of the workload (present and future) of each die, power measurements of each die, and other parameters (e.g., platform level power boundaries) and determines new power limits for each die. These power limits are then communicated by supervisor p-units to the supervisee p-units via one or more interconnects and fabrics. In some embodiments, a fabric indicates a group of fabrics and interconnect including a first fabric, a second fabric, and a fast response interconnect. In some embodiments, the first fabric is used for common communication between a supervisor p-unit and a supervisee p-unit. These common communications include change in voltage, frequency, and/or power state of a die which is planned based on a number of factors (e.g., future workload, user behavior, etc.). In some embodiments, the second fabric is used for higher priority communication between supervisor p-unit and supervisee p-unit. Example of higher priority communication include a message to throttle because of a possible thermal runaway condition, reliability issue, etc. In some embodiments, a fast response interconnect is used for communicating fast or hard throttle of all dies. In this case, a supervisor p-unit may send a fast throttle message to all other p-units, for example. In some embodiments, a fast response interconnect is a legacy interconnect whose function can be performed by the second fabric.

The HPM architecture of various embodiments enables scalability, modularity, and late binding of symmetric and/or asymmetric dies. Here, symmetric dies are dies of same size, type, and/or function, while asymmetric dies are dies of different size, type, and/or function. Hierarchical approach also allows PMU functions that may already exist on other dice to be leveraged, instead of being disabled in the traditional flat power management scheme. HPM does not assume a pre-determined mapping of physical partitions to domains. An HPM domain can be aligned with a function integrated inside a dielet, to a dielet boundary, to one or more dielets, to a companion die, or even a discrete CXL device. HPM enables management of any arbitrary collection of functions independent of their level of integration. In some embodiments, a p-unit is declared a supervisor p-unit based on one or more factors. These factors include memory size, physical constraints (e.g., number of pin-outs), and locations of sensors (e.g., temperature, power consumption, etc.) to determine physical limits of the processor.

The HPM architecture of various embodiments, provides a means to scale power management so that a single p-unit instance does not need to be aware of the entire processor. This enables power management at a smaller granularity and improves response times and effectiveness. Hierarchical structure maintains a monolithic view to the user. For example, at an operating system (OS) level, HPM architecture gives the OS a single PMU view even though the PMU is physically distributed in one or more supervisor-supervisee configurations.

In some embodiments, the HPM architecture is centralized where one supervisor controls all supervisees. In some embodiments, the HPM architecture is decentralized, wherein various p-units in various dies control overall power management by peer-to-peer communication. In some embodiments, the HPM architecture is distributed where there are different supervisors for different domains. One example of a distributed architecture is a tree-like architecture.

In some embodiments, device 5500 comprises Power Management Integrated Circuit (PMIC) 5512, e.g., to implement various power management operations for device 5500. In some embodiments, PMIC 5512 is a Reconfigurable Power Management ICs (RPMICs) and/or an IMVP (Intel^{®} Mobile Voltage Positioning). In an example, the PMIC is within an IC die separate from processor 5504. The may implement various power management operations for device 5500. PMIC 5512 may include hardware interfaces, hardware circuitries, connectors, registers, etc., as well as software components (e.g., drivers, protocol stacks), to implement various power management operations for device 5500.

In an example, device 5500 comprises one or both PCU 5510 or PMIC 5512. In an example, any one of PCU 5510 or PMIC 5512 may be absent in device 5500, and hence, these components are illustrated using dotted lines.

Various power management operations of device 5500 may be performed by PCU 5510, by PMIC 5512, or by a combination of PCU 5510 and PMIC 5512. For example, PCU 5510 and/or PMIC 5512 may select a power state (e.g., P-state) for various components of device 5500. For example, PCU 5510 and/or PMIC 5512 may select a power state (e.g., in accordance with the ACPI (Advanced Configuration and Power Interface) specification) for various components of device 5500. Merely as an example, PCU 5510 and/or PMIC 5512 may cause various components of the device 5500 to transition to a sleep state, to an active state, to an appropriate C state (e.g., C0 state, or another appropriate C state, in accordance with the ACPI specification), etc. In an example, PCU 5510 and/or PMIC 5512 may control a voltage output by VR 5514 and/or a frequency of a clock signal output by the clock generator, e.g., by outputting the VID signal and/or the FID signal, respectively. In an example, PCU 5510 and/or PMIC 5512 may control battery power usage, charging of battery 5518, and features related to power saving operation.

The clock generator 5516 can comprise a phase locked loop (PLL), frequency locked loop (FLL), or any suitable clock source. In some embodiments, each core of processor 5504 has its own clock source. As such, each core can operate at a frequency independent of the frequency of operation of the other core. In some embodiments, PCU 5510 and/or PMIC 5512 performs adaptive or dynamic frequency scaling or adjustment. For example, clock frequency of a processor core can be increased if the core is not operating at its maximum power consumption threshold or limit. In some embodiments, PCU 5510 and/or PMIC 5512 determines the operating condition of each core of a processor, and opportunistically adjusts frequency and/or power supply voltage of that core without the core clocking source (e.g., PLL of that core) losing lock when the PCU 5510 and/or PMIC 5512 determines that the core is operating below a target performance level. For example, if a core is drawing current from a power supply rail less than a total current allocated for that core or processor 5504, then PCU 5510 and/or PMIC 5512 can temporality increase the power draw for that core or processor 5504 (e.g., by increasing clock frequency and/or power supply voltage level) so that the core or processor 5504 can perform at higher performance level. As such, voltage and/or frequency can be increased temporality for processor 5504 without violating product reliability.

In an example, PCU 5510 and/or PMIC 5512 may perform power management operations, e.g., based at least in part on receiving measurements from power measurement circuitries 5542, temperature measurement circuitries 5540, charge level of battery 5518, and/or any other appropriate information that may be used for power management. To that end, PMIC 5512 is communicatively coupled to one or more sensors to sense/detect various values/variations in one or more factors having an effect on power/thermal behavior of the system/platform. Examples of the one or more factors include electrical current, voltage droop, temperature, operating frequency, operating voltage, power consumption, inter-core communication activity, etc. One or more of these sensors may be provided in physical proximity (and/or thermal contact/coupling) with one or more components or logic/IP blocks of a computing system. Additionally, sensor(s) may be directly coupled to PCU 5510 and/or PMIC 5512 in at least one embodiment to allow PCU 5510 and/or PMIC 5512 to manage processor core energy at least in part based on value(s) detected by one or more of the sensors.

Also illustrated is an example software stack of device 5500 (although not all elements of the software stack are illustrated). Merely as an example, processors 5504 may execute application programs 5550, Operating System 5552, one or more Power Management (PM) specific application programs (e.g., generically referred to as PM applications 5558), and/or the like. PM applications 5558 may also be executed by the PCU 5510 and/or PMIC 5512. OS 5552 may also include one or more PM applications 5556a, 5556b, 5556c. The OS 5552 may also include various drivers 5554a, 5554b, 5554c, etc., some of which may be specific for power management purposes. In some embodiments, device 5500 may further comprise a Basic Input/output System (BIOS) 5520. BIOS 5520 may communicate with OS 5552 (e.g., via one or more drivers 5554), communicate with processors 5504, etc.

For example, one or more of PM applications 5558, 5556, drivers 5554, BIOS 5520, etc. may be used to implement power management specific tasks, e.g., to control voltage and/or frequency of various components of device 5500, to control wake-up state, sleep state, and/or any other appropriate power state of various components of device 5500, control battery power usage, charging of the battery 5518, features related to power saving operation, etc.

In some embodiments, battery 5518 is a Li-metal battery with a pressure chamber to allow uniform pressure on a battery. The pressure chamber is supported by metal plates (such as pressure equalization plate) used to give uniform pressure to the battery. The pressure chamber may include pressured gas, elastic material, spring plate, etc. The outer skin of the pressure chamber is free to bow, restrained at its edges by (metal) skin, but still exerts a uniform pressure on the plate that is compressing the battery cell. The pressure chamber gives uniform pressure to battery, which is used to enable high-energy density battery with, for example, 20% more battery life.

In some embodiments, battery 5518 includes hybrid technologies. For example, a mix of high energy density charge (e.g., Li-ion batteries) carrying device(s) and low energy density charge carrying devices (e.g., supercapacitor) are used as batteries or storage devices. In some embodiments, a controller (e.g., hardware, software, or a combination of them) is used analyze peak power patterns and minimizes the impact to overall lifespan of high energy density charge carrying device-based battery cells while maximizing service time for peak power shaving feature. The controller may be part of battery 5518 or part of p-unit 5510b.

In some embodiments, pCode executing on PCU 5510a/b has a capability to enable extra compute and telemetries resources for the runtime support of the pCode. Here pCode refers to a firmware executed by PCU 5510a/b to manage performance of the SoC 5501. For example, pCode may set frequencies and appropriate voltages for the processor. Part of the pCode are accessible via OS 5552. In various embodiments, mechanisms and methods are provided that dynamically change an Energy Performance Preference (EPP) value based on workloads, user behavior, and/or system conditions. There may be a well-defined interface between OS 5552 and the pCode. The interface may allow or facilitate the software configuration of several parameters and/or may provide hints to the pCode. As an example, an EPP parameter may inform a pCode algorithm as to whether performance or battery life is more important.

This support may be done as well by the OS 5552 by including machine-learning support as part of OS 5552 and either tuning the EPP value that the OS hints to the hardware (e.g., various components of SoC 5501) by machine-learning prediction, or by delivering the machine-learning prediction to the pCode in a manner similar to that done by a Dynamic Tuning Technology (DTT) driver. In this model, OS 5552 may have visibility to the same set of telemetries as are available to a DTT. As a result of a DTT machine-learning hint setting, pCode may tune its internal algorithms to achieve optimal power and performance results following the machine-learning prediction of activation type. The pCode as example may increase the responsibility for the processor utilization change to enable fast response for user activity, or may increase the bias for energy saving either by reducing the responsibility for the processor utilization or by saving more power and increasing the performance lost by tuning the energy saving optimization. This approach may facilitate saving more battery life in case the types of activities enabled lose some performance level over what the system can enable. The pCode may include an algorithm for dynamic EPP that may take the two inputs, one from OS 5552 and the other from software such as DTT, and may selectively choose to provide higher performance and/or responsiveness. As part of this method, the pCode may enable in the DTT an option to tune its reaction for the DTT for different types of activity.

In some embodiments, pCode improves the performance of the SoC in battery mode. In some embodiments, pCode allows drastically higher SoC peak power limit levels (and thus higher Turbo performance) in battery mode. In some embodiments, pCode implements power throttling and is part of Intel's Dynamic Tuning Technology (DTT). In various embodiments, the peak power limit is referred to PL4. However, the embodiments are applicable to other peak power limits. In some embodiments, pCode sets the *Vth* threshold voltage (the voltage level at which the platform will throttle the SoC) in such a way as to prevent the system from unexpected shutdown (or black screening). In some embodiments, pCode calculates the *Psoc,pk* SoC Peak Power Limit (e.g., PL4), according to the threshold voltage (*Vth*). These are two dependent parameters, if one is set, the other can be calculated. pCode is used to optimally set one parameter (*Vth*) based on the system parameters, and the history of the operation. In some embodiments, pCode provides a scheme to dynamically calculate the throttling level (*Psoc,th*) based on the available battery power (which changes slowly) and set the SoC throttling peak power (*Psoc,th*). In some embodiments, pCode decides the frequencies and voltages based on *Psoc,th.* In this case, throttling events have less negative effect on the SoC performance. Various embodiments provide a scheme which allows maximum performance (Pmax) framework to operate.

In some embodiments, VR 5514 includes a current sensor to sense and/or measure current through a high-side switch of VR 5514. In some embodiments the current sensor uses an amplifier with capacitively coupled inputs in feedback to sense the input offset of the amplifier, which can be compensated for during measurement. In some embodiments, the amplifier with capacitively coupled inputs in feedback is used to operate the amplifier in a region where the input common-mode specifications are relaxed, so that the feedback loop gain and/or bandwidth is higher. In some embodiments, the amplifier with capacitively coupled inputs in feedback is used to operate the sensor from the converter input voltage by employing high-PSRR (power supply rejection ratio) regulators to create a local, clean supply voltage, causing less disruption to the power grid in the switch area. In some embodiments, a variant of the design can be used to sample the difference between the input voltage and the controller supply, and recreate that between the drain voltages of the power and replica switches. This allows the sensor to not be exposed to the power supply voltage. In some embodiments, the amplifier with capacitively coupled inputs in feedback is used to compensate for power delivery network related (PDN-related) changes in the input voltage during current sensing.

Some embodiments use three components to adjust the peak power of SoC 5501 based on the states of a USB TYPE-C device 5529. These components include OS Peak Power Manager (part of OS 5552), USB TYPE-C Connector Manager (part of OS 5552), and USB TYPE-C Protocol Device Driver (e.g., one of drivers 5554a, 5554b, 5554c). In some embodiments, the USB TYPE-C Connector Manager sends a synchronous request to the OS Peak Power Manager when a USB TYPE-C power sink device is attached or detached from SoC 5501, and the USB TYPE-C Protocol Device Driver sends a synchronous request to the Peak Power Manager when the power sink transitions device state. In some embodiments, the Peak Power Manager takes power budget from the CPU when the USB TYPE-C connector is attached to a power sink and is active (e.g., high power device state). In some embodiments, the Peak Power Manager gives back the power budget to the CPU for performance when the USB TYPE-C connector is either detached or the attached and power sink device is idle (lowest device state).

In some embodiments, logic is provided to dynamically pick the best operating processing core for BIOS power-up flows and sleep exit flows (e.g., S3, S4, and/or S5). The selection of the bootstrap processor (BSP) is moved to an early power-up time instead of a fixed hardware selection at any time. For maximum boot performance, the logic selects the fastest capable core as the BSP at an early power-up time. In addition, for maximum power saving, the logic selects the most power efficient core as the BSP. Processor or switching for selecting the BSP happens during the boot-up as well as power-up flows (e.g., S3, S4, and/or S5 flows).

In some embodiments, the memories herein are organized in multi-level memory architecture and their performance is governed by a decentralized scheme. The decentralized scheme includes p-unit 5510 and memory controllers. In some embodiments, the scheme dynamically balances a number of parameters such as power, thermals, cost, latency and performance for memory levels that are progressively further away from the processor in platform 5500 based on how applications are using memory levels that are further away from processor cores. In some examples, the decision making for the state of the far memory (FM) is decentralized. For example, a processor power management unit (p-unit), near memory controller (NMC), and/or far memory host controller (FMHC) makes decisions about the power and/or performance state of the FM at their respective levels. These decisions are coordinated to provide the most optimum power and/or performance state of the FM for a given time. The power and/or performance state of the memories adaptively change to changing workloads and other parameters even when the processor(s) is in a particular power state.

In some embodiments, a hardware and software coordinated processor power state policy (e.g., policy for C-state) is implemented that delivers optimal power state selection by taking in to account the performance and/or responsiveness needs of thread expected to be scheduled on the core entering idle, to achieve improved instructions per cycle (IPC) and performance for cores running user critical tasks. The scheme provides the ability to deliver responsiveness gains for important and/or user-critical threads running on a system-on-chip. P-unit 5510 which coupled to the plurality of processing cores, receives a hint from operating system 5552 indicative of a bias towards a power state or performance state for at least one of the processing cores of the plurality of processing cores based on a priority of a thread in context switch.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "adjacent" here generally refers to a position of a thing being next to (e.g., immediately next to or close to with one or more things between them) or adjoining another thing (e.g., abutting it).

The term "circuit" or "module" may refer to one or more passive and/or active components that are arranged to cooperate with one another to provide a desired function.

The term "signal" may refer to at least one current signal, voltage signal, magnetic signal, or data/clock signal. The meaning of "a," "an," and "the" include plural references. The meaning of "in" includes "in" and "on."

The term "analog signal" is any continuous signal for which the time varying feature (variable) of the signal is a representation of some other time varying quantity, i.e., analogous to another time varying signal.

The term "digital signal" is a physical signal that is a representation of a sequence of discrete values (a quantified discrete-time signal), for example of an arbitrary bit stream, or of a digitized (sampled and analog-to-digital converted) analog signal.

The term "scaling" generally refers to converting a design (schematic and layout) from one process technology to another process technology and may be subsequently being reduced in layout area. In some cases, scaling also refers to upsizing a design from one process technology to another process technology and may be subsequently increasing layout area. The term "scaling" generally also refers to downsizing or upsizing layout and devices within the same technology node. The term "scaling" may also refer to adjusting (e.g., slowing down or speeding up - i.e. scaling down, or scaling up respectively) of a signal frequency relative to another parameter, for example, power supply level.

The terms "substantially," "close," "approximately," "near," and "about," generally refer to being within +/- 10% of a target value.

Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

The terms "left," "right," "front," "back," "top," "bottom," "over," "under," and the like in the description and in the claims, if any, are used for descriptive purposes and not necessarily for describing permanent relative positions.

It is pointed out that those elements of the figures having the same reference numbers (or names) as the elements of any other figure can operate or function in any manner similar to that described but are not limited to such.

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors (BJT PNP/NPN), BiCMOS, CMOS, etc., may be used without departing from the scope of the disclosure.

Here the term "die" generally refers to a single continuous piece of semiconductor material (e.g. silicon) where transistors or other components making up a processor core may reside. Multi-core processors may have two or more processors on a single die, but alternatively, the two or more processors may be provided on two or more respective dies. Each die has a dedicated power controller or power control unit (p-unit) power controller or power control unit (p-unit) which can be dynamically or statically configured as a supervisor or supervisee. In some examples, dies are of the same size and functionality i.e., symmetric cores. However, dies can also be asymmetric. For example, some dies have different size and/or function than other dies. Each processor may also be a dielet or chiplet. Here the term "dielet" or "chiplet" generally refers to a physically distinct semiconductor die, typically connected to an adjacent die in a way that allows the fabric across a die boundary to function like a single fabric rather than as two distinct fabrics. Thus at least some dies may be dielets. Each dielet may include one or more p-units which can be dynamically or statically configured as a supervisor, supervisee or both.

Here the term "fabric" generally refers to communication mechanism having a known set of sources, destinations, routing rules, topology and other properties. The sources and destinations may be any type of data handling functional unit such as power management units. Fabrics can be two-dimensional spanning along an x-y plane of a die and/or three-dimensional (3D) spanning along an x-y-z plane of a stack of vertical and horizontally positioned dies. A single fabric may span multiple dies. A fabric can take any topology such as mesh topology, star topology, daisy chain topology. A fabric may be part of a network-on-chip (NoC) with multiple agents. These agents can be any functional unit.

Here, the term "processor core" generally refers to an independent execution unit that can run one program thread at a time in parallel with other cores. A processor core may include a dedicated power controller or power control unit (p-unit) which can be dynamically or statically configured as a supervisor or supervisee. This dedicated p-unit is also referred to as an autonomous p-unit, in some examples. In some examples, all processor cores are of the same size and functionality i.e., symmetric cores. However, processor cores can also be asymmetric. For example, some processor cores have different size and/or function than other processor cores. A processor core can be a virtual processor core or a physical processor core.

Here, the term "interconnect" refers to a communication link, or channel, between two or more points or nodes. It may comprise one or more separate conduction paths such as wires, vias, waveguides, passive components, and/or active components. It may also comprise a fabric.

Here the term "interface" generally refers to software and/or hardware used to communicate with an interconnect. An interface may include logic and I/O driver/receiver to send and receive data over the interconnect or one or more wires.

Here the term "domain" generally refers to a logical or physical perimeter that has similar properties (e.g., supply voltage, operating frequency, type of circuits or logic, and/or workload type) and/or is controlled by a particular agent. For example, a domain may be a group of logic units or function units that are controlled by a particular supervisor. A domain may also be referred to as an Autonomous Perimeter (AP). A domain can be an entire system-on-chip (SoC) or part of the SoC, and is governed by a p-unit.

Here the term "supervisor" generally refers to a power controller, or power management, unit (a "p-unit"), which monitors and manages power and performance related parameters for one or more associated power domains, either alone or in cooperation with one or more other p-units. Power/performance related parameters may include but are not limited to domain power, platform power, voltage, voltage domain current, die current, load-line, temperature, device latency, utilization, clock frequency, processing efficiency, current/future workload information, and other parameters. It may determine new power or performance parameters (limits, average operational, etc.) for the one or more domains. These parameters may then be communicated to supervisee p-units, or directly to controlled or monitored entities such as VR or clock throttle control registers, via one or more fabrics and/or interconnects. A supervisor learns of the workload (present and future) of one or more dies, power measurements of the one or more dies, and other parameters (e.g., platform level power boundaries) and determines new power limits for the one or more dies. These power limits are then communicated by supervisor p-units to the supervisee p-units via one or more fabrics and/or interconnect. In examples where a die has one p-unit, a supervisor (Svor) p-unit is also referred to as supervisor die.

Here the term "supervisee" generally refers to a power controller, or power management, unit (a "p-unit"), which monitors and manages power and performance related parameters for one or more associated power domains, either alone or in cooperation with one or more other p-units and receives instructions from a supervisor to set power and/or performance parameters (e.g., supply voltage, operating frequency, maximum current, throttling threshold, etc.) for its associated power domain. In examples where a die has one p-unit, a supervisee (Svee) p-unit may also be referred to as a supervisee die. Note that a p-unit may serve either as a Svor, a Svee, or both a Svor/Svee p-unit.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

Various embodiments are described as examples. The examples can be combined in any suitable manner. For instance, example 5 can be combined with example 3 and/or example 7.

Example 1: An apparatus comprising: a voltage regulator coupled to an input supply rail and an output supply rail; a logic coupled to the voltage regulator, wherein the logic is to control the voltage regulator based on user attentiveness such that: the input supply rail is electrically shorted to the output supply rail in a first mode, and a voltage on the input supply rail is divided and a divided voltage is provided on the output supply rail in a second mode.

Example 2: The apparatus of example 1, wherein the logic applies machine-learning to classify user attentiveness.

Example 3: The apparatus of example 1 comprising a power gate to bypass the voltage regulator in the first mode.

Example 4: The apparatus of example 1, wherein at least two alternate transistors in series in the voltage regulator are turned off to operate in the second mode.

Example 5: The apparatus of example 1, wherein at least two sequentially connected transistors in series in the voltage regulator are turned off to operate in the first mode.

Example 6: The apparatus of example 1, wherein the logic is part of a processor or system-on-chip.

Example 7: The apparatus of example 1, wherein the voltage regulator is a switched capacitor voltage regulator.

Example 8: The apparatus of example 1 comprising a battery to provide the voltage on the input supply rail.

Example 9: The apparatus of example 8, wherein the battery is a 4S battery.

Example 10: An apparatus comprising: a battery to provide an input supply on an input supply rail; a voltage regulator coupled to an input supply rail and the battery, the voltage regulator having an output coupled to an output supply rail; a logic coupled to the voltage regulator, wherein the logic is to dynamically control a mode of operation of the voltage regulator based on user attentiveness.

Example 11: The apparatus of example 10, wherein the logic is to configure the voltage regulator in a divider mode of operation based on the user attentiveness being determined to be attentive.

Example 12: The apparatus of example 11, wherein at least two alternate transistors in series in the voltage regulator are turned off to operate in the divider mode.

Example 13: The apparatus of example 10, wherein the logic is to configure the voltage regulator in a bypass mode of operation based on the user attentiveness being determined to be inattentive or the user attentiveness is below a threshold.

Example 14: The apparatus of example 13, wherein at least two sequentially connected transistors in series in the voltage regulator are turned off to operate in the bypass mode.

Example 15: The apparatus of example 10, wherein the logic is to bypass the voltage regulator based on the user attentiveness being determined to be inattentive or the user attentiveness is below a threshold.

Example 16: The apparatus of example 15 comprising a power gate to bypass the voltage regulator in the bypass mode.

Example 17: The apparatus of example 10, wherein the logic applies machine-learning to classify user attentiveness.

Example 18: The apparatus of example 1, wherein the voltage regulator is a switched capacitor voltage regulator.

Example 19: A system comprising: a charger; a battery coupled to the charger, the battery to provide an input supply on an input supply rail; a voltage regulator coupled to an input supply rail and the battery, the voltage regulator having an output coupled to an output supply rail; a memory; and a processor coupled to the voltage regulator and the memory, wherein the processor is to adaptively control a mode of operation of the voltage regulator based on user attentiveness.

Example 20: The system of example 19, wherein: the processor is to configure the voltage regulator in a divider mode of operation based on the user attentiveness being determined to be attentive, wherein at least two alternate transistors in series in the voltage regulator are turned off to operate in the divider mode; and the processor is to configure the voltage regulator in a bypass mode of operation based on the user attentiveness being determined to be inattentive or the user attentiveness is below a threshold, wherein at least two sequentially connected transistors in series in the voltage regulator are turned off to operate in the bypass mode.

Example 21: An apparatus comprising: a charger comprising a voltage regulator, wherein the charger is operable in AC mode or DC mode, and wherein the voltage regulator is operable in bypass mode or voltage divider mode when the charger is in DC mode; and a transistor coupled to the charger and a battery, wherein the transistor decouples the battery from the voltage regulator in the AC mode.

Example 22: The apparatus of example 21, wherein the transistor is turned off in the bypass mode.

Example 23: The apparatus of example 21, wherein the voltage regulator is a switch capacitor voltage regulator.

Example 24: The apparatus of example 21 comprising a logic coupled to the voltage regulator, wherein the logic is to dynamically control a mode of operation of the voltage regulator based on user attentiveness, wherein the mode of operation is bypass mode or voltage divider mode.

Example 25: The apparatus of example 24, wherein the logic is to configure the voltage regulator in a divider mode of operation based on the user attentiveness being determined to be attentive.

Example 26: The apparatus of example 24, wherein the logic is to configure the voltage regulator in a bypass mode of operation based on the user attentiveness being determined to be inattentive or the user attentiveness is below a threshold.

Example 27: The apparatus of example 24, wherein the logic is to bypass the voltage regulator based on the user attentiveness being determined to be inattentive or the user attentiveness is below a threshold.

Example 28: The apparatus of example 27 comprising a power gate to bypass the voltage regulator in the bypass mode.

Example 29: The apparatus of example 24, wherein the logic applies machine-learning to classify user attentiveness.

Example 30: The apparatus of example 21 comprises a battery transistor coupled in series with the battery, wherein the battery transistor is turned on in AC mode.

Example 31: The apparatus of example 30, wherein the battery transistor is turned off in DC mode.

Example 32: An apparatus comprising: a battery having a state-of-charge, wherein the battery is coupled to an input supply rail; a voltage regulator coupled to the input supply rail and an output supply rail; and a logic coupled to the voltage regulator, wherein the logic is to dynamically control a conversion ratio of the voltage regulator based on user attentiveness and the state-of-charge.

Example 33: The apparatus of example 32, wherein the logic is to keep a higher conversion ratio when the state-of-charge is above a threshold.

Example 34: The apparatus of example 32, wherein the logic is to keep a lower conversion ratio when the state-of-charge is below a threshold and the user attentiveness is determined to be interactive.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus comprising:
a voltage regulator coupled to an input supply rail and an output supply rail; and
a logic coupled to the voltage regulator, wherein the logic is to control the voltage regulator based on user attentiveness such that:
the input supply rail is electrically shorted to the output supply rail in a first mode, and
a voltage on the input supply rail is divided and a divided voltage is provided on the output supply rail in a second mode.

2. The apparatus of claim 1, wherein the logic applies machine-learning to classify user attentiveness.

3. The apparatus of claim 1 or claim 2, further comprising a power gate to bypass the voltage regulator in the first mode.

4. The apparatus of any one of claims 1 to 3, wherein at least two alternate transistors in series in the voltage regulator are turned off to operate in the second mode.

5. The apparatus of any one of claims 1 to 4, wherein at least two sequentially connected transistors in series in the voltage regulator are turned off to operate in the first mode.

6. The apparatus of any one of claims 1 to 5, wherein the logic is part of a processor or system-on-chip.

7. The apparatus of any one of claims 1 to 6, wherein the voltage regulator is a switched capacitor voltage regulator.

8. The apparatus of any one of claims 1 to 7, further comprising a battery to provide the voltage on the input supply rail.

9. The apparatus of claim 8, wherein the battery is a 4S battery.

10. A device comprising:
a battery to provide an input supply on an input supply rail; and
the apparatus of any one of claims 1 to 9 coupled to the input supply rail.

11. A system comprising:
a charger;
a battery coupled to the charger, the battery to provide an input supply on an input supply rail;
a voltage regulator coupled to an input supply rail and the battery, the voltage regulator having an output coupled to an output supply rail;
a memory; and
a processor coupled to the voltage regulator and the memory, wherein the processor is to adaptively control a mode of operation of the voltage regulator based on user attentiveness.

12. The system of claim 11, wherein:
the processor is to configure the voltage regulator in a divider mode of operation based on the user attentiveness being determined to be attentive, wherein at least two alternate transistors in series in the voltage regulator are turned off to operate in the divider mode; and
the processor is to configure the voltage regulator in a bypass mode of operation based on the user attentiveness being determined to be inattentive or the user attentiveness is below a threshold, wherein at least two sequentially connected transistors in series in the voltage regulator are turned off to operate in the bypass mode.
